(19) Europäisches Patentamt
European Patent Office
Office européen des brevets

(11) **EP 4 039 772 A1**

(12) **EUROPEAN PATENT APPLICATION**
published in accordance with Art. 153(4) EPC


(43) Date of publication:
**10.08.2022 Bulletin 2022/32**

(21) Application number: **20871785.0**

(22) Date of filing: **25.09.2020**

(51) International Patent Classification (IPC):
***C09K 11/06*** *(2006.01)* ***H01S 5/36*** *(2006.01)*
***H01L 51/50*** *(2006.01)*

(52) Cooperative Patent Classification (CPC):
**C09K 11/06; H01L 51/50; H01S 5/36**

(86) International application number:
**PCT/JP2020/036305**

(87) International publication number:
**WO 2021/065725 (08.04.2021 Gazette 2021/14)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **30.09.2019 JP 2019178599**



(71) Applicants:
- **Kyushu University, National University Corporation**
  **Nishi-ku**
  **Fukuoka-shi**
  **Fukuoka 819-0395 (JP)**
- **KOALA Tech Inc.**
  **Fukuoka-shi, Fukuoka 819-0388 (JP)**

(72) Inventors:
- **SANDANAYAKA, Sangarange Don Atula**
  **Fukuoka-shi, Fukuoka 819-0395 (JP)**
- **KARUNATHILAKA, Kohona Pahala Walawwe Buddhika**
  **Sanjeewa Bandara**
  **Fukuoka-shi, Fukuoka 819-0395 (JP)**
- **BALIJAPALLI, Umamahesh**
  **Fukuoka-shi, Fukuoka 819-0395 (JP)**
- **SENEVIRATHNE, Adikari Mudiyanselage Chathuranganie**
  **Fukuoka-shi, Fukuoka 819-0395 (JP)**
- **MATSUSHIMA, Toshinori**
  **Fukuoka-shi, Fukuoka 819-0395 (JP)**
- **ADACHI, Chihaya**
  **Fukuoka-shi, Fukuoka 819-0395 (JP)**

(74) Representative: **Zimmermann & Partner**
**Patentanwälte mbB**
**Postfach 330 920**
**80069 München (DE)**


(54) **LASER ELEMENT, COMPOUND, METHOD FOR PRODUCING COMPOUND AND LASING SENSITIZER**


(57) Disclosed is a laser device containing a compound represented by the following formula in a light-emitting layer. $R^1$ and $R^5$ each represent a substituent having a positive Hammett's $\sigma_p$ value, and $R^2$ to $R^4$, and $R^6$ to $R^{15}$ each represent a hydrogen atom or a substituent.


EP 4 039 772 A1

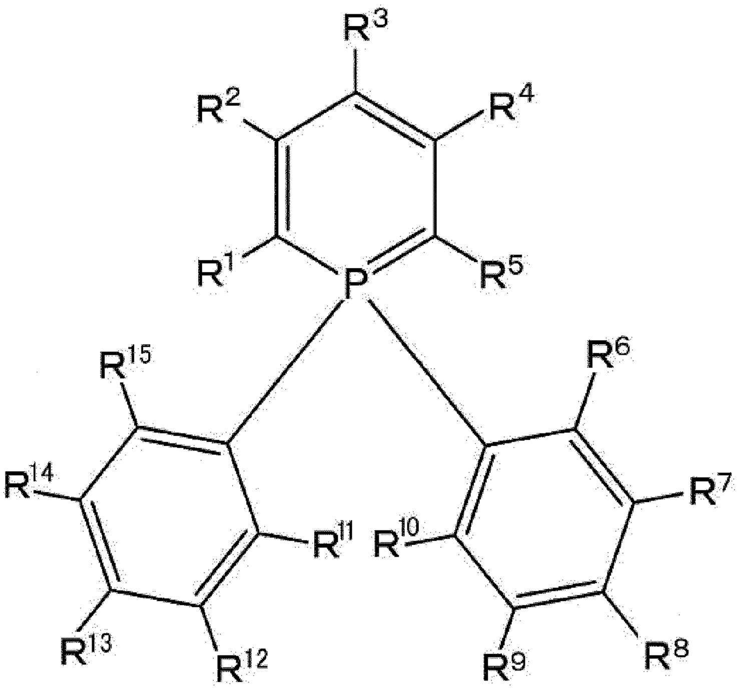

[FIG. 4]

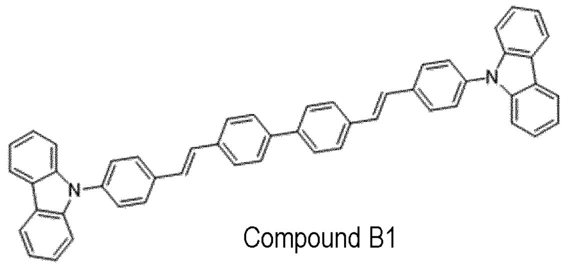

Compound B1

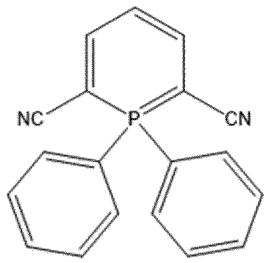

Compound 1

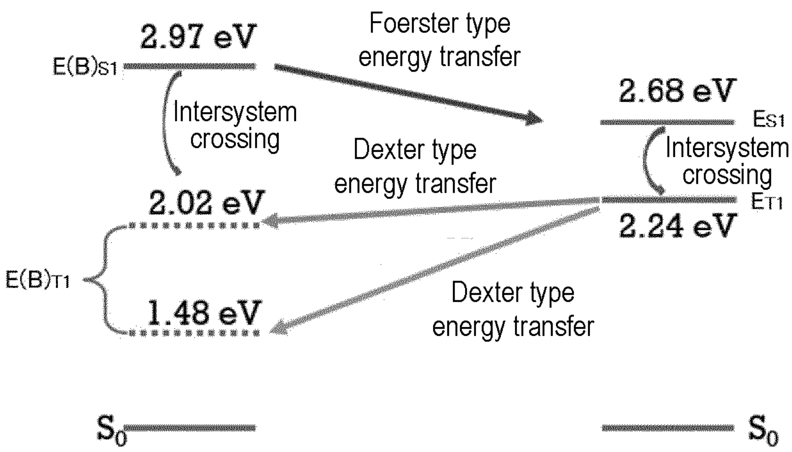

## Description

Technical Field

The present invention relates to a compound and a lasing sensitizer useful as materials for a light-emitting layer of a laser device.

Background Art

Studies toward realization of an organic semiconductor laser device having a low lasing threshold have been actively carried out. In particular, for realizing such an organic semiconductor laser device, development of a compound that enables amplified spontaneous emission (ASE) is indispensable, and therefore studies of synthesizing various compounds, investigating the ASE characteristics thereof and finding out compounds useful as a laser material have been intensively progressed. Among them, there are seen studies of molecular designing based on a stilbene structure as a basic structure to realize a laser material having a low amplified spontaneous emission threshold (ASE threshold).

For example, NPL 1 reports that a bisstilbene derivative (BSBCz) represented by the following formula shows an extremely low ASE threshold and is excellent as an organic laser dye.

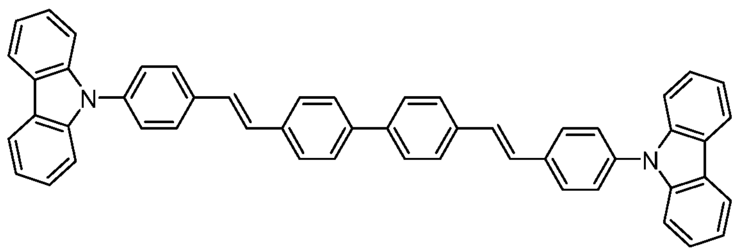

BSBCz

Citation List

Non-Patent Literature

NPL 1: Appl. Phys. Lett. 2005, 86, 071110

Summary of Invention

Technical Problem

As described above, usefulness of a compound having a stilbene structure as a lasing material has been investigated. However, only the compound having a stilbene structure limits the light emission wavelength and lasing characteristics realized, and limits the application range of organic laser devices. Accordingly, in order to improve the versatility of organic laser devices, development of new lasing materials is required. On the other hand, the above-mentioned BSBCz has a characteristic electron state in that it has an electron-donating carbazolyl group at both ends of a long π-conjugated system, and is expected to have some other useful applications in addition to lasing materials.

Given the situation, the present inventors have made further assiduous studies to provide a new lasing material. Further, the present inventors have made intensive studies for the purpose of developing new applications of BSBCz and its analogue compounds.

Solution to Problem

As a result of assiduous studies, the present inventors have found that a phosphinine derivative having a specific structure is useful as a lasing material. In addition, the inventors have also found that BSBCz and its analogue compounds can effectively function as a lasing sensitizer that promotes the light-emitting process of a lasing material. The present invention has been proposed based on these findings and specifically has the following constitution.

[1] A laser device containing a compound represented by the following formula (1) in a light-emitting layer.

Formula (1)

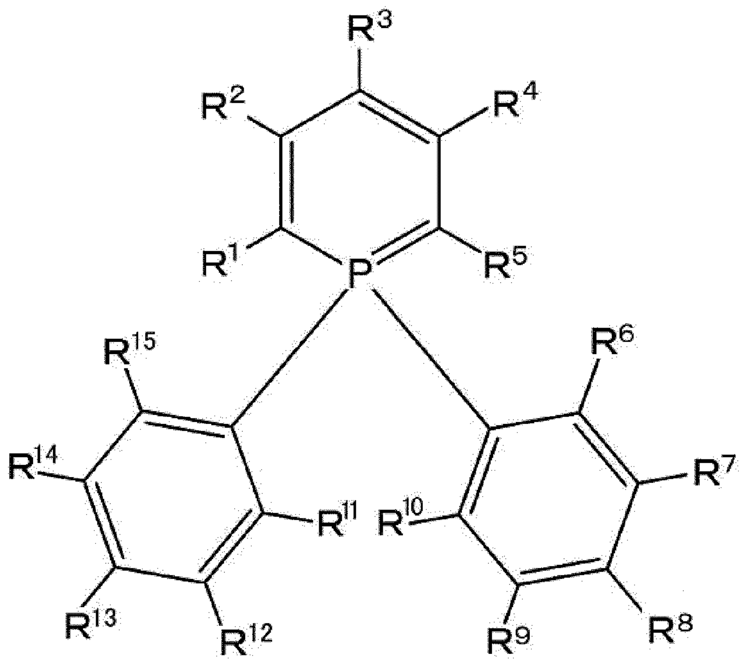

In the formula (1), $R^1$ and $R^5$ each independently represent a substituent having a positive Hammett's $\sigma_p$ value, and $R^2$ to $R^4$, and $R^6$ to $R^{15}$ each independently represent a hydrogen atom or a substituent.

[2] The laser device according to [1], wherein $R^1$ and $R^5$ each are independently a cyano group, an aryl group substituted with a cyano group, or a heteroaryl group having a nitrogen atom as a ring skeleton constituting atom, and wherein the aryl group may be further substituted with any other group than a cyano group and the heteroaryl group may be substituted.

[3] The laser device according to [1] or [2], wherein $R^2$ to $R^4$ each are independently a hydrogen atom or a substituent having a positive Hammett's $\sigma_p$ value.

[4] The laser device according to [3], wherein the substituent having a positive Hammett's $\sigma_p$ value is an aryl group substituted with a cyano group, and wherein the aryl group may be further substituted with any other group than a cyano group.

[5] The laser device according to [1] or [2], wherein $R^2$ to $R^4$ each are independently a hydrogen atom or a substituent having a negative Hammett's $\sigma_p$ value.

[6] The laser device according to [5], wherein the substituent having a negative Hammett's $\sigma_p$ value is a group containing a substituted or unsubstituted diarylamino structure.

[7] The laser device according to [6], wherein the group containing a substituted or unsubstituted diarylamino structure contains a linking group that links the diarylamino structure to the phosphinine ring in the formula (1).

[8] The laser device according to [1] or [2], wherein $R^2$ to $R^4$ each are independently a hydrogen atom, a substituted or unsubstituted aryl group, or a group represented by $R^{16}CO$-, and $R^{16}$ represents a hydrogen atom or a substituent.

[9] The laser device according to [8], wherein the substituted or unsubstituted aryl group contains a condensed ring having a benzene ring unit.

[10] The laser device according to any one of [1] to [9], wherein $R^3$ is a substituent.

[11] The laser device according to any one of [1] to [10], containing a compound represented by the following formula (2) in the light-emitting layer.

Formula (2) $Z^1$-L-$Z^2$

In the formula (2), $Z^1$ and $Z^2$ each independently represent a substituted or unsubstituted diarylamino group, and the two aryl groups constituting the diarylamino group bond to each other directly or via a linking group. L represents a conjugated linking group that contains both a substituted or unsubstituted arylene group and a substituted or unsubstituted ethenylene group.

[12] The laser device according to [11], wherein the content of the compound represented by the formula (1) in the light-emitting layer is 0.01 to 10% by mass, and the content of the compound represented by the formula (2) therein

is larger than the content of the compound represented by the formula (1).

[13] The laser device according to [11] or [12], wherein the emission-excited singlet energy level of the compound represented by the formula (1) is lower than the emission-excited singlet energy level of the compound represented by the formula (2), and the emission-excited triplet energy level of the compound represented by the formula (1) is higher than the emission-excited triplet energy level of the compound represented by the formula (2).

[14] A compound represented by the following formula (3).

Formula (3)

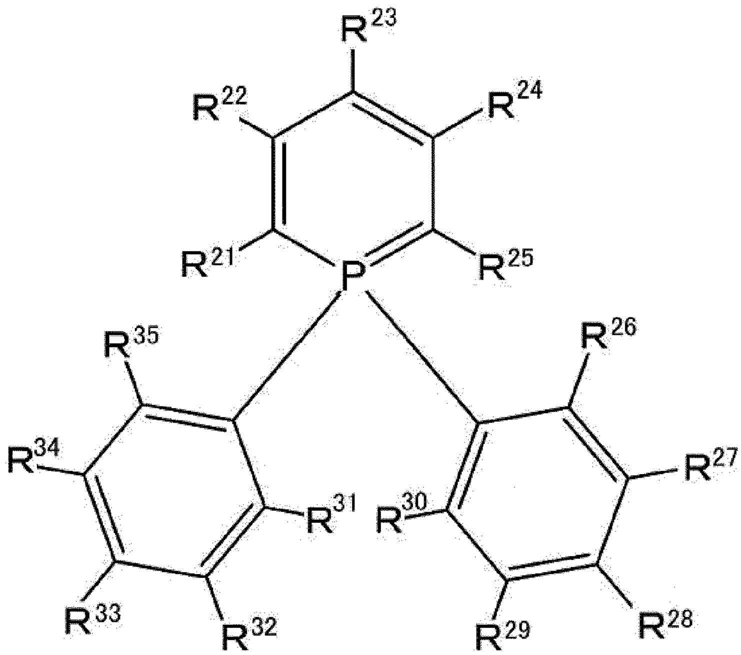

In the formula (3), $R^{21}$ and $R^{25}$ each independently represent a substituent having a positive Hammett's $\sigma_p$ value, $R^{23}$ represents a substituent, $R^{22}$, $R^{24}$, and $R^{26}$ to $R^{35}$ each independently represent a hydrogen atom or a substituent. However, when $R^{21}$ and $R^{25}$ each are a cyano group, $R^{23}$ is a substituted aryl group, or a substituted or unsubstituted heteroaryl group.

[15] The compound according to [14], wherein $R^{23}$ is a substituted aryl group.

[16] The compound according to [14] or [15], wherein $R^{21}$ and $R^{25}$ each are a cyano group.

[17] A method for producing a compound represented by a formula (4), including a step of halogenating the 4-position of a 2,6-dicyano-1,1-diphenylphosphinine in which the 4-position is unsubstituted and the other position may be substituted, and a step of afterward reacting it with a compound represented by $R^{43}$-H.

Formula (4)

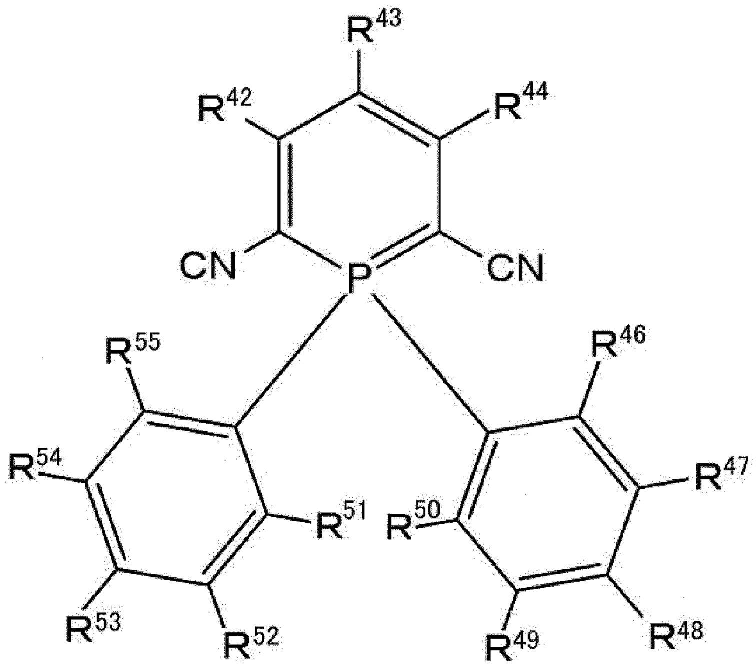

In the formula (4), $R^{43}$ represents a substituted aryl group, or a substituted or unsubstituted heteroaryl group, and $R^{42}$, $R^{44}$, and $R^{46}$ to $R^{55}$ each independently represent a hydrogen atom or a substituent.

[18] A lasing sensitizer containing a compound represented by the formula (2).

[19] A laser device having a light-emitting layer that contains a lasing sensitizer of [18] and a light-emitting material, wherein the emission-excited singlet energy level of the light-emitting material is smaller than the emission-excited singlet energy level of the lasing sensitizer, and the emission-excited triplet energy level of the light-emitting material is higher than the emission-excited triplet energy level of the lasing sensitizer.

Advantageous Effects of Invention

The compound of the present invention is useful as a lasing material, and with that, the present invention can provide a lasing material whose skeleton structure differs from that of BSBCz. In addition, the laser device of the present invention can realize excellent lasing characteristics. Using the lasing sensitizer of the present invention, the lasing characteristics of laser devices can be improved.

Brief Description of Drawings

[Fig. 1] This is a schematic cross-sectional view showing a layer configuration example of a laser device of the present invention.

[Fig. 2] This shows emission spectra of a toluene solution of Compounds 1 to 3, 5, and 7 to 12.

[Fig. 3] This shows optical absorption spectra and emission spectra of a single film of Compound 1, a single film of Compound B1, and a mixed film of Compound 1 and Compound B1.

[Fig. 4] This is an energy level diagram showing an energy relationship and energy transfer process of Compound 1 and Compound B1.

[Fig. 5] This is a schematic cross-sectional view showing a layer configuration of a distributed-feedback emission excitation laser device produced in Examples 1 to 3.

[Fig. 6] This is a schematic cross-sectional view showing a layer configuration of a distributed-feedback current excitation laser device produced in Examples 4 to 7.

Description of Embodiments

Hereinunder the contents of the present invention will be described in detail. The constitutional elements may

be described below with reference to representative embodiments and specific examples of the invention, but the invention is not limited to the embodiments and the examples. In the description herein, a numerical range expressed as "AA to BB" means a range that includes the upper limit of AA and/or the lower limit of BB indicating the range expressed as "AA to BB". In the description, the hydrogen atom that is present in the molecule in the compound used in the invention is not particularly limited in isotope species, and for example, all the hydrogen atoms in the molecule may be $^1H$, and all or a part of them may be $^2H$ (deuterium (D)).

<Laser Device (First Laser Device)>

The laser device (first laser device) of the present invention contains a compound represented by the following formula (1) in a light-emitting layer.

Containing a compound represented by the formula (1) in a light-emitting layer, the laser device of the present invention exhibits excellent lasing characteristics. This is presumed to be because the compound represented by the formula (1) can readily form an inverted distribution of excited singlet and in addition, can undergo radiative deactivation from the emission-excited singlet state at a higher speed than the intersystem crossing speed from the excited singlet state to the excited triplet state, owing to spontaneous emission or external photoirradiation.

The light-emitting layer may be formed of only the compound represented by the formula (1), or can contain any other material. In the following, the compound represented by the formula (1) and other light-emitting layer materials are described.

[Compound represented by formula (1)]

Formula (1)

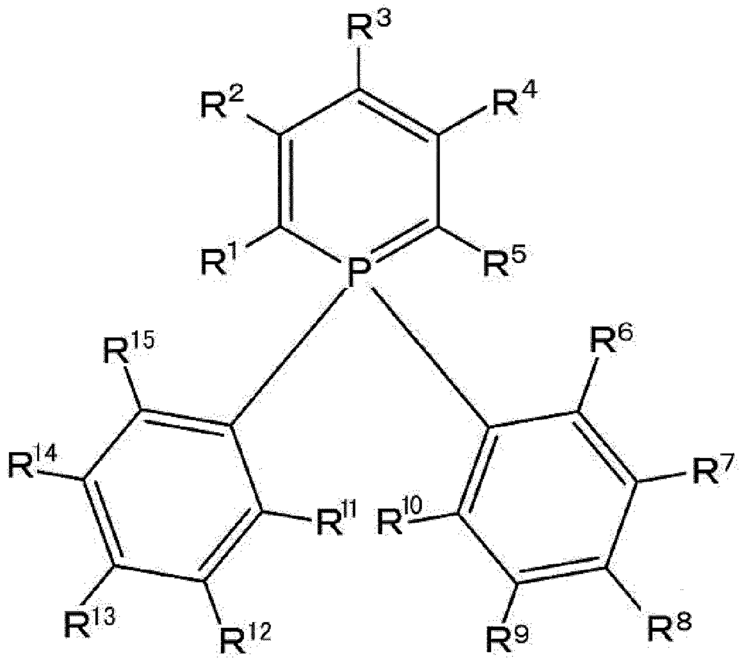

In the formula (1), $R^1$ and $R^5$ each independently represent a substituent having a positive Hammett's $\sigma_p$ value. $R^1$ and $R^5$ may be the same as or different from each other, but are preferably the same. When $R^1$ and $R^5$ each are independently a substituent having a positive Hammett's $\sigma_p$ value, the phosphinine structure tends to stabilize.

Here, "Hammett's $\sigma_p$ value" is one propounded by L. P. Hammett, and is one to quantify the influence of a substituent on the reaction rate or the equilibrium of a para-substituted benzene derivative. Specifically, the value is a constant ($\sigma_p$) peculiar to the substituent in the following equation that is established between a substituent and a reaction rate constant or an equilibrium constant in a para-substituted benzene derivative:

$$\log(k/k_0) = \rho\sigma_p$$

or

$$\log(K/K_0) = \rho\sigma_p$$

In the above equations, k represents a rate constant of a benzene derivative not having a substituent; $k_0$ represents a rate constant of a benzene derivative substituted with a substituent; K represents an equilibrium constant of a benzene derivative not having a substituent; Ko represents an equilibrium constant of a benzene derivative substituted with a substituent; $\rho$ represents a reaction constant to be determined by the kind and the condition of reaction. Regarding the description relating to the "Hammett's $\sigma_p$ value" in the present invention and the numerical value of each substituent, reference may be made to the description relating to $\sigma_p$ value in Hansch, C. et. al., Chem. Rev., 91, 165-195 (1991). A substituent having a negative Hammett's $\sigma p$ value tends to exhibit electron-donating performance (donor-like performance) and a substituent having a positive Hammett's $\sigma p$ value tends to exhibit electron-accepting performance (acceptor-like performance).

Preferably, $R^1$ and $R^5$ each are independently a cyano group, an aryl group substituted with a cyano group, or a heteroaryl group having a nitrogen atom as a ring skeleton constituting atom. Here, the aryl group substituted with a cyano group may be further substituted with any other group than a cyano group, and the heteroaryl group having a nitrogen atom as a ring skeleton constituting atom may be substituted.

In the aryl group substituted with a cyano group, the aromatic ring constituting the aryl group may be a single ring, or may be a condensed ring formed by condensation of 2 or more aromatic rings, or may be a linked ring formed of 2 or more aromatic rings linking together. In the case where 2 or more aromatic rings link together, they may link in a linear manner or in a branched manner. The carbon number of the aromatic ring to constitute the aryl group is preferably 6 to 22, more preferably 6 to 18, even more preferably 6 to 14, further more preferably 6 to 10. Specific examples of the aryl group include a phenyl group, a naphthyl group and a biphenyl group.

The number of substitution with a cyano group and the substitution position thereof in the aryl group are not specifically limited. A part of the substitutable positions of the aryl group may be substituted with a cyano group, or all of the substitutable positions of the aryl group may be substituted with a cyano group. Here, "substitutable position" means a position of a hydrogen atom substitutable with a substituent. Examples of the hydrogen atom substitutable with a substituent include hydrogen atoms of a methine group that constitute an aryl group. In the case where a part of the substitutable positions of the aryl group is substituted with a cyano group, the remaining substitutable positions may be substituted with any other substituent than a cyano group or may be unsubstituted.

In the heteroaryl group having a nitrogen atom as a ring skeleton constituting atom, the heterocyclic aromatic ring that constitutes the heteroaryl group may be a single ring, or may be a condensed ring formed by condensation of 2 or more nitrogen atom-having heterocyclic aromatic rings, or may be a condensed ring formed by condensation of at least one nitrogen atom-having heterocyclic aromatic ring and at least one aromatic ring. The heterocyclic aromatic ring that constitute the heteroaryl group preferably contains a 6-membered rind having a nitrogen atom as a ring skeleton constituting atom, and preferably, the number of the nitrogen atoms in the 6-membered ring is 1 to 3. Specific examples of the 6-membered ring having a nitrogen atom as a ring skeleton constituting atom include a pyridine ring, a pyrazine ring, a pyrimidine ring, a pyridazine ring, and a triazine ring. The heteroaryl group having a nitrogen atom as a ring skeleton constituting atom may be substituted with a substituent.

Examples of the substituent with which the cyano group-substituted aryl group may be further substituted, and the substituent with which the heteroaryl group having a nitrogen atom as a ring skeleton constituting atom may be substituted include an alkyl group having 1 to 20 carbon atoms, an aryl group having 6 to 40 carbon atoms, a cyano group, a halogen atom and a heteroaryl group having 5 to 40 carbon atoms. The substitutable groups may be substituted with the substituent of those substituents.

In the formula (1), $R^2$ to $R^4$, and $R^6$ to $R^{15}$ each independently represent a hydrogen atom or a substituent. $R^2$ to $R^4$, and $R^6$ to $R^{15}$ may be the same as or different from each other.

Preferably, $R^2$ to $R^4$ are each independently a hydrogen atom or a substituent having a positive Hammett's $\sigma_p$ value, or also preferably, these are each independently a hydrogen atom or a substituent having a negative Hammett's $\sigma_p$ value, or also preferably, these are each independently a hydrogen atom, a substituted or unsubstituted aryl group, or a group represented by $R^{16}CO$-. Here, $R^{16}$ in $R^{16}CO$- is a hydrogen atom or a substituent.

Regarding the description of "substituent having a positive Hammett's $\sigma_p$ value" in $R^2$ to $R^4$, and the preferred range and the specific examples of the substituent that $R^2$ to $R^4$ represent, reference may be made to the description of "substituent having a positive Hammett's $\sigma_p$ value" in $R^1$ and $R^5$, and to the preferred range and the specific examples of the substituent that $R^1$ and $R^5$ represent. Among these, a more preferred substituent is an aryl group substituted with

a cyano group.

Preferred examples of the "substituent having a negative Hammett's $\sigma_p$ value" in $R^2$ to $R^4$ include a group having a substituted or unsubstituted diarylamino structure. Here, "diarylamino structure" means both a diarylamino group, and a heterocyclic aromatic ring structure in which the aryl groups of a diarylamino group bond to each other via a single bond or a linking group to form a hetero ring. Regarding the description, the preferred range and the specific examples of the aromatic ring that constitutes each aryl group of the diarylamino structure, reference may be made to the description, the preferred range and the specific examples of the aromatic ring that constitutes the above-mentioned aryl group. Regarding the description and the preferred range of the substituent in the case where the diarylamino structure has a substituent, reference may be made to the description and the preferred range of the substituent that $R^{61}$ to $R^{70}$ in the following formula (5) can have. Regarding the description and the preferred range of the linking group that links the aryl groups in the case where the diarylamino structure is the above-mentioned heterocyclic aromatic ring structure, reference may be made to the description and the preferred range in the case where $R^{65}$ and $R^{66}$ in the following formula (5) link to each other to form a linking group. The diarylamino structure may link to the phosphinine ring in the formula (1) via the carbon atom of each aryl group, or may link via the nitrogen atom to which each aryl group bonds. Also, the carbon atom or the nitrogen atom may bond to the carbon atom that constitutes the phosphinine ring via a single bond, or may link thereto via a linking group. Namely, the diarylamino structure-containing group may contain a linking group that links the diarylamino structure to the phosphinine ring. The linking group that links the diarylamino structure to the benzene ring is, though not specifically limited, preferably a substituted or unsubstituted arylene group. Regarding the description, the preferred range and the specific examples of the substituted or unsubstituted arylene group, reference may be made to the description, the preferred range and the specific examples of the substituted or unsubstituted arylene group of $L^{61}$ in the following formula (5). Regarding the description and the preferred range of the substituent in the case where the arylene group has a substituent, reference may be made to the description and the preferred range of the substituent which $R^{61}$ to $R^{70}$ in the following formula (5) can have.

The diarylamino structure-containing group is preferably a group represented by the following formula (5) or the following formula (6).

Formula (5)

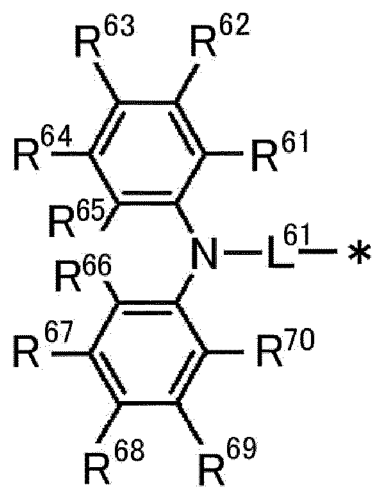

Formula (6)

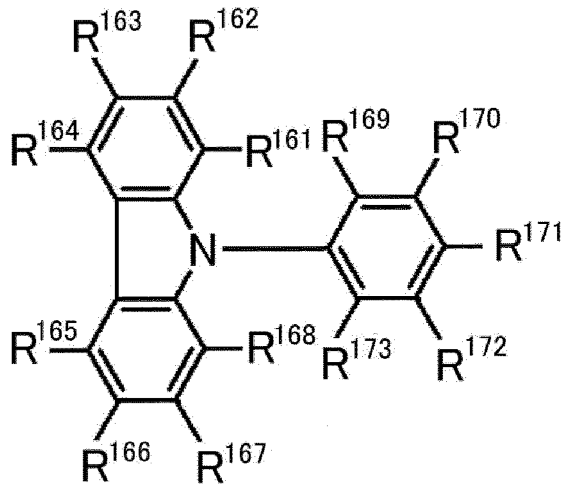

In the formulae (5) and (6), $R^{61}$ to $R^{70}$, and $R^{165}$ to $R^{173}$ each independently represent a hydrogen atom or a substituent. One of $R^{161}$ to $R^{164}$ represents a bonding position to the phosphinine ring in the formula (1), and the remaining $R^{161}$ to $R^{164}$ each independently represent a hydrogen atom or a substituent. The number of the substituents is not specifically limited, and all $R^{61}$ to $R^{70}$, and $R^{161}$ to $R^{173}$ (but excluding the bonding position to the phosphinine ring) may be unsubstituted (that is, all hydrogen atoms), or in the case where two or more of $R^{61}$ to $R^{70}$ are substituents, the plural substituents may be the same as or different from each other. In the case where two or more of $R^{161}$ to $R^{173}$ are substituents, the plural substituents may be the same as or different from each other.

Examples of the substituent that $R^{61}$ to $R^{70}$, and $R^{161}$ to $R^{173}$ can have include a hydroxy group, a halogen atom, an alkyl group having 1 to 20 carbon atoms, an alkoxy group having 1 to 20 carbon atoms, an alkylthio group having 1 to 20 carbon atoms, an alkyl-substituted amino group having 1 to 20 carbon atoms, an aryl-substituted amino group having 6 to 20 carbon atoms, an aryl group having 6 to 40 carbon atoms, a heteroaryl group having 3 to 40 carbon atoms, an alkenyl group having 2 to 10 carbon atoms, an alkynyl group having 2 to 10 carbon atoms, an alkylamide group having 2 to 20 carbon atoms, an arylamide group having 7 to 21 carbon atoms, and a trialkylsilyl group having 3 to 20 carbon atoms. Among these specific examples, those that are further substitutable with a substituent can be substituted. More preferred substituents are an alkyl group having 1 to 20 carbon atoms, an alkoxy group having 1 to 20 carbon atoms, an alkylthio group having 1 to 20 carbon atoms, an alkyl-substituted amino group having 1 to 20 carbon atoms, an aryl-substituted amino group having 1 to 20 carbon atoms, an aryl group having 6 to 40 carbon atoms, and a heteroaryl group having 3 to 40 carbon atoms.

$R^{61}$ and $R^{62}$, $R^{62}$ and $R^{63}$, $R^{63}$ and $R^{64}$, $R^{64}$ and $R^{65}$, $R^{65}$ and $R^{66}$, $R^{66}$ and $R^{67}$, $R^{67}$ and $R^{68}$, $R^{68}$ and $R^{69}$, $R^{69}$ and $R^{70}$, $R^{161}$ and $R^{162}$, $R^{162}$ and $R^{163}$, $R^{163}$ and $R^{164}$, $R^{165}$ and $R^{166}$, $R^{166}$ and $R^{167}$, $R^{167}$ and $R^{168}$, $R^{169}$ and $R^{170}$ $R^{170}$ and $R^{171}$ and $R^{172}$, and $R^{172}$ and $R^{173}$ each may bond to each other to form a cyclic structure. The cyclic structure may be an aromatic ring or an aliphatic ring, or may contain a hetero atom, and further the cyclic structure may be a condensed ring of two or more rings. The hetero atom referred to herein is preferably selected from the group consisting of a nitrogen atom, an oxygen atom and a sulfur atom. Examples of the cyclic structure to be formed include a benzene ring, a naphthalene ring, a pyridine ring, a pyridazine ring, a pyrimidine ring, a pyrazine ring, a pyrrole ring, an imidazole ring, a pyrazole ring, an imidazolidine ring, an oxazole ring, an isoxazole ring, a thiazole ring, an isothiazole ring, a cyclohexadiene ring, a cyclohexene ring, a cyclopentaene ring, a cycloheptatriene ring, a cycloheptadiene ring, and a cycloheptaene ring.

Among the groups represented by the formula (5), preferred are those where $R^{65}$ and $R^{66}$ do not bond to each other, those where $R^{65}$ and $R^{66}$ bond to each other to form a single bond, or those where $R^{65}$ and $R^{66}$ bond to each other to form a linking group having a linking chain length of one atom; and more preferred are those where $R^{65}$ and $R^{66}$ do not bond to each other, or those where $R^{65}$ and $R^{66}$ bond to each other to form a single bond. In the case where $R^{65}$ and $R^{66}$ bond to each other to form a linking group having a linking chain length of one atom, the cyclic structure formed as a result of bonding of $R^{65}$ and $R^{66}$ to each other is a 6-membered ring. Specific examples of the linking group formed by bonding of $R^{65}$ and $R^{66}$ to each other include linking groups represented by - O-, -S-, -N($R^{191}$)- or -C($R^{192}$)($R^{193}$)-. In these, $R^{191}$ to $R^{193}$ each independently represent a hydrogen atom or a substituent. Examples of the substituent that $R^{191}$ can have include an alkyl group having 1 to 20 carbon atoms, an aryl group having 6 to 40 carbon atoms, and a heteroaryl group having 3 to 40 carbon atoms. Examples of the substituent that $R^{192}$ and $R^{193}$ each independently can have a hydroxy group, a halogen atom, an alkyl group having 1 to 20 carbon atoms, an alkoxy

group having 1 to 20 carbon atoms, an alkylthio group having 1 to 20 carbon atoms, an alkyl-substituted amino group having 1 to 20 carbon atoms, an aryl-substituted amino group having 12 to 40 carbon atoms, an aryl group having 6 to 40 carbon atoms, a heteroaryl group having 3 to 40 carbon atoms, an alkenyl group having 2 to 10 carbon atoms, an alkynyl group having 2 to 10 carbon atoms, an alkylamide group having 2 to 20 carbon atoms, an arylamide group having 7 to 21 carbon atoms, and a trialkylsilyl group having 3 to 20 carbon atoms.

$L^{61}$ represents a single bond or a substituted or unsubstituted arylene group. Regarding the description, the preferred range and the specific examples of the aromatic ring that constitutes the arylene group, reference may be made to the description, the preferred range and the specific examples of the aromatic ring that constitutes the above-mentioned aryl group. Specific examples of the substituted or unsubstituted arylene group of $L^{61}$ include a substituted or unsubstituted phenylene group, a substituted or unsubstituted naphthylene group and a biphenyl-diyl group, and preferred is a substituted or unsubstituted phenylene group. The phenylene group may be any of a 1,2-phenylene group, a 1,3-phenylene group, or a 1,4-phenylene group, but is preferably a 1,4-phenylene group. Regarding the description and the preferred range of the substituent in the case where the arylene group has a substituent, reference may be made to the description and the preferred range of the substituent that the above-mentioned $R^{61}$ to $R^{70}$ can have.

* indicates a bonding position.

Preferred examples of the group represented by the formula (5) include groups represented by any of the following formulae (7) to (11).

Formula (7)

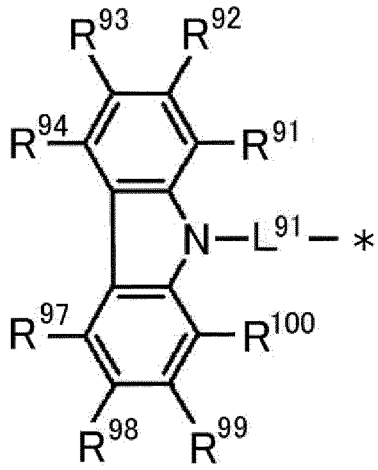

Formula (8)

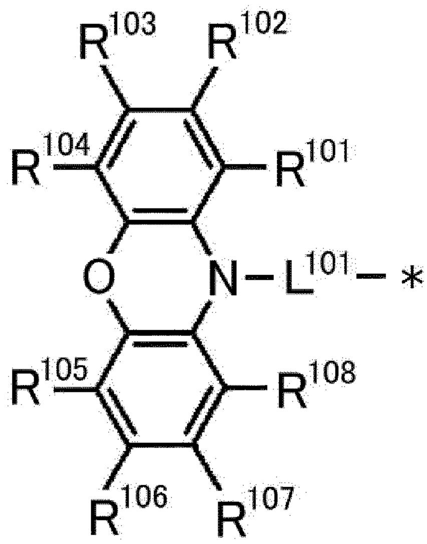

Formula (9)

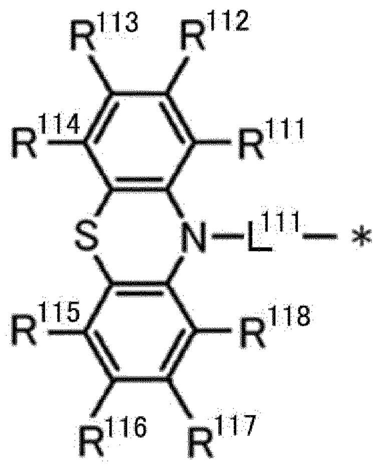

Formula (10)

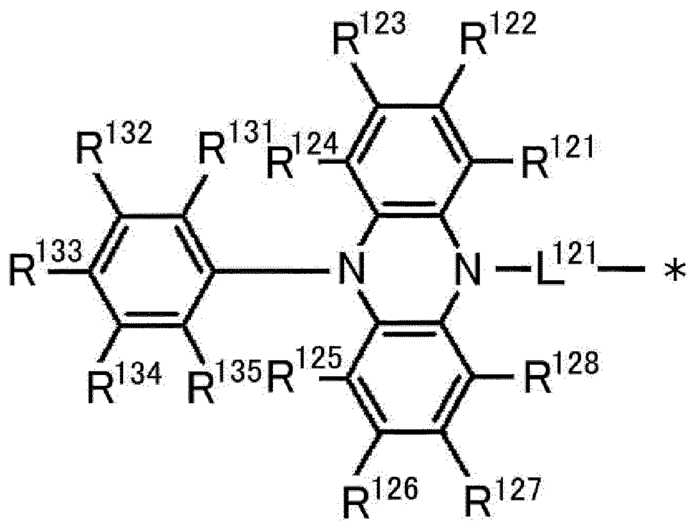

Formula (11)

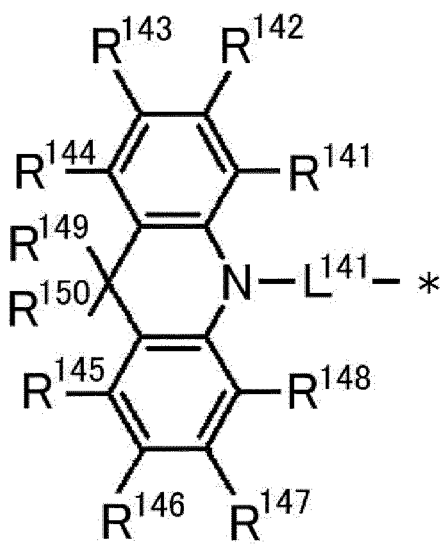

In the formulae (7) to (11), $R^{91}$ to $R^{94}$, $R^{97}$ to $R^{108}$, $R^{111}$ to $R^{118}$, $R^{121}$ to $R^{128}$, $R^{131}$ to $R^{135}$, and $R^{141}$ to $R^{150}$ each independently represent a hydrogen atom or a substituent. $R^{91}$ and $R^{92}$, $R^{92}$ and $R^{93}$, $R^{93}$ and $R^{94}$, $R^{97}$ and $R^{98}$, $R^{98}$ and $R^{99}$, $R^{99}$ and $R^{100}$, $R^{101}$ and $R^{102}$, $R^{102}$ and $R^{103}$, $R^{103}$ and $R^{104}$, $R^{105}$ and $R^{106}$, $R^{106}$ and $R^{107}$, $R^{107}$ and $R^{108}$, $R^{111}$ and $R^{112}$, $R^{112}$ and $R^{113}$, $R^{113}$ and $R^{114}$, $R^{115}$ and $R^{116}$, $R^{116}$ and $R^{117}$, $R^{117}$ and $R^{118}$, $R^{121}$ and $R^{122}$, $R^{122}$ and $R^{123}$, $R^{123}$ and $R^{124}$, $R^{125}$ and $R^{126}$, $R^{126}$ and $R^{127}$, $R^{127}$ and $R^{128}$, $R^{131}$ and $R^{132}$, $R^{132}$ and $R^{133}$, $R^{133}$ and $R^{134}$, $R^{134}$ and $R^{135}$, $R^{124}$ and $R^{131}$, $R^{125}$ and $R^{135}$, $R^{141}$ and $R^{142}$, $R^{142}$ and $R^{143}$, $R^{143}$ and $R^{144}$ $R^{145}$ and $R^{146}$, $R^{146}$ and $R^{147}$, $R^{147}$ and $R^{148}$, and $R^{149}$ and $R^{150}$ each may bond to each other to form a cyclic structure. $L^{91}$, $L^{101}$, $L^{111}$, $L^{121}$, and $L^{141}$ each independently represent a single bond, or a substituted or unsubstituted arylene group. * indicates a bonding position.

Regarding the description, the preferred range and the specific examples of the substituent, the cyclic structure and the substituted or unsubstituted arylene group as referred to herein, reference may be made to the description, the preferred range and the specific examples of the substituent, the cyclic structure and the substituted or unsubstituted arylene group in the formula (5).

In the formula (1), the aromatic ring that constitutes the substituted or unsubstituted aryl group of $R^2$ to $R^4$ may be a single ring, or may also be a condensed ring formed by condensation of two or more aromatic rings, or a condensed ring formed by condensation of at least one aromatic ring and at least one cycloalkene, a spiro ring where two or more aromatic rings bond to a spiro atom, or a linking ring of two or more aromatic rings linking to each other. In the case where two or more aromatic rings link to each other, they may link linearly or may link in a branched manner. Above all, the aromatic ring that constitutes the aryl group is preferably a condensed ring containing a benzene ring unit. The carbon number of the aromatic ring that constitutes the aryl group is preferably 6 to 25. Specific examples of the aryl group include a phenyl group, a naphthyl group, a biphenyl group, a triphenylenyl group, a fluorenyl group, and an 9,9'-spirobifluorenyl group. Regarding the description and the preferred range of the substituent in the case where the aryl group has a substituent, reference may be made to the description and the preferred range of the substituent that the above-mentioned $R^{61}$ to $R^{70}$ can have.

$R^{16}$ of the group represented by $R^{16}CO$- in $R^2$ to $R^4$ may be a hydrogen atom or may also be a substituent. Examples of the substituent include a substituted or unsubstituted alkyl group, a substituted or unsubstituted aryl group, a halogen atom, and a cyano group.

The number of the substituents of $R^2$ to $R^4$ is not specifically limited, and preferably all are unsubstituted. Also preferably, at least one of $R^2$ to $R^4$ is a substituent. Regarding the substituent, preferably at least $R^3$ among $R^2$ to $R^4$ is a substituent, and the substituent is preferably an unsaturated bond-containing substituent, more preferably a substituent containing an aromatic ring. By changing the structure of the substituent of $R^3$, the emission wavelength of the laser device can be readily controlled. For example, in the case where a substituent having a negative $\sigma p$ is introduced into $R^3$, the emission wavelength tends to shift toward a long wavelength side, while in the case where a substituent having a positive $\sigma p$ is introduced into $R^3$, the emission wavelength tends to shift toward a short wavelength side, as compared with the case where a substituent having a negative $\sigma p$ is introduced thereinto.

$R^6$ to $R^{15}$ may be a hydrogen atom or may also be a substituent. The number of the substituents among $R^6$ to $R^{15}$ is not specifically limited, and all may be unsubstituted. Regarding the description and the preferred range of the substituent that $R^6$ to $R^{15}$ can have, reference may be made to the description and the preferred range of the substituent that $R^{61}$ to $R^{70}$ can have.

Preferred examples and specific examples of the compound represented by the formula (1) are shown below. However, the compound represented by the formula (1) usable in the present invention should not be limitatively interpreted by these specific examples. In the following formulae, Ph represents a phenyl group, Me represents a methyl group, and R represents Ph (phenyl group) or Me (methyl group).

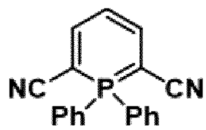

Compound 1

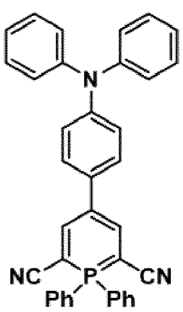 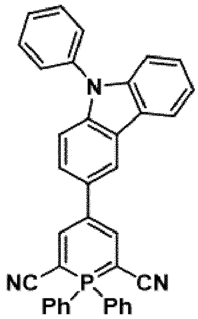 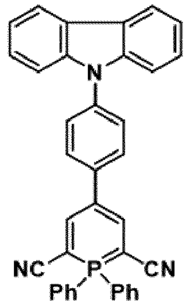 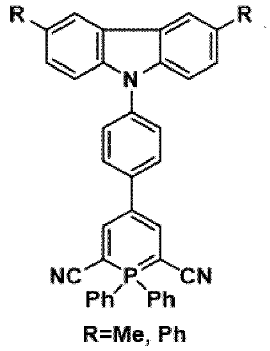 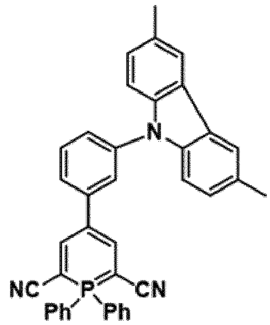

Compound 2 Compound 3 Compound 4 R = Me: Compound 5 Compound 7

Ph: Compound 6

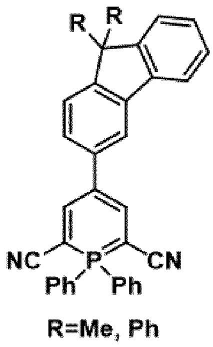 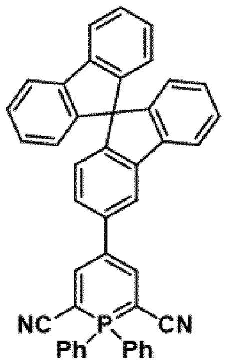 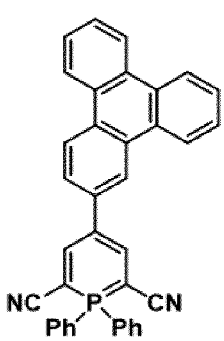 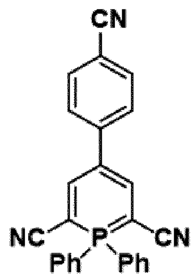 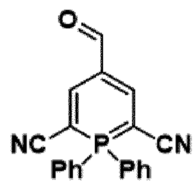

R = Me: Compound 8 Compound 10 Compound 11 Compound 12 Compound 13

Ph: Compound 9

The compound represented by the formula (1) is also preferably a compound represented by the following formula (1a).

Formula (1a)

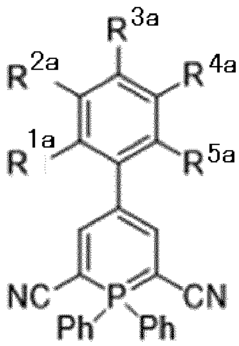

In the formula (1a), $R^{1a}$ to $R^{5a}$ each independently represent a hydrogen atom or a substituent selected from the following Substituent Group (a), and at least one of $R^{1a}$ to $R^{5a}$ is a substituent selected from the following Substituent Group (a).

Substituent Group (a)

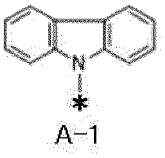

A-1

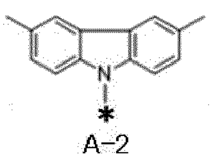

A-2

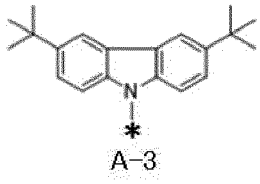

A-3

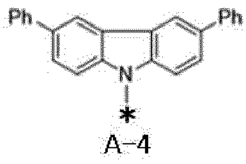

A-4

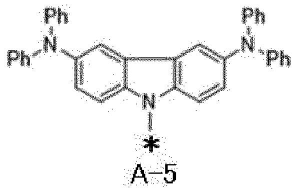

A-5

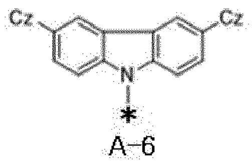

A-6

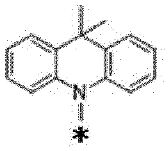

A-7

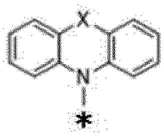

X
O : A-8
S : A-9

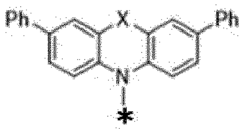

X
O : A-10
S : A-11

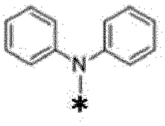

A-12

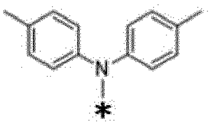

A-13

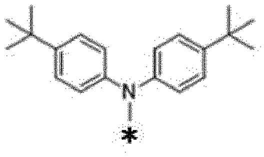

A-14

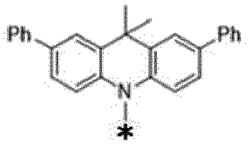

A-15

In the formulae, Ph represents a phenyl group, and Cz represents a carbazolyl group. * indicates a bonding position to the benzene ring in the formula (1a).

Specific examples of the compound represented by the formula (1a) are compounds where one of $R^{1a}$ to $R^{5a}$ is a group selected from the Substituent Group (a), and the remaining $R^{1a}$ to $R^{5a}$ are hydrogen atoms. Above all, the compound represented by the formula (1a) is preferably any of compounds represented by the following formulae.

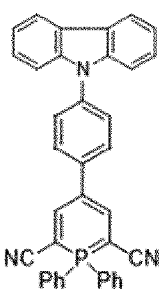

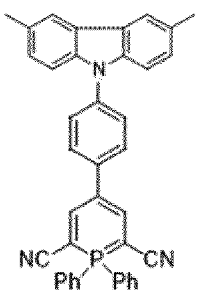

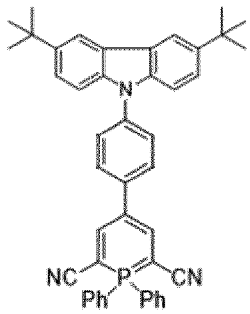

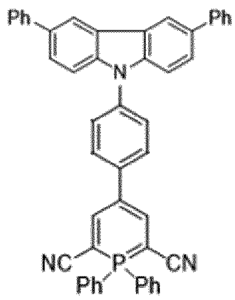

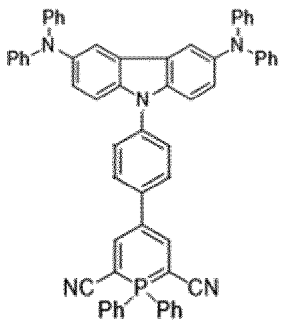 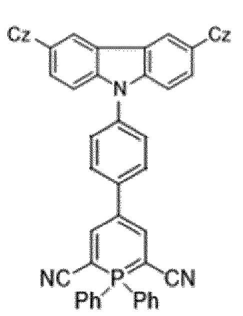 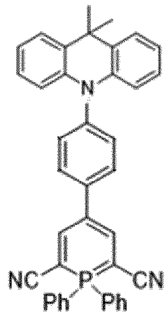

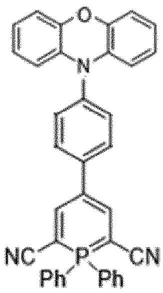 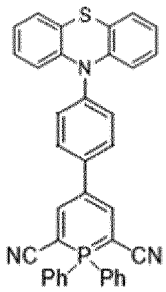 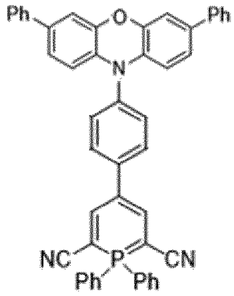 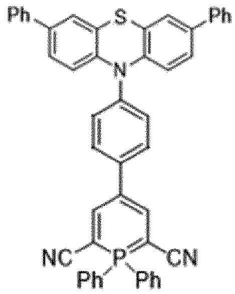

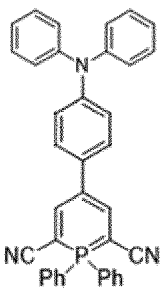 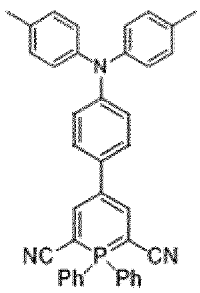 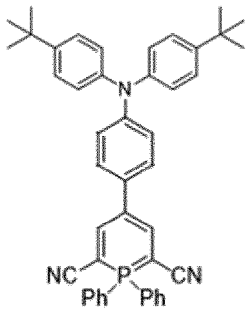 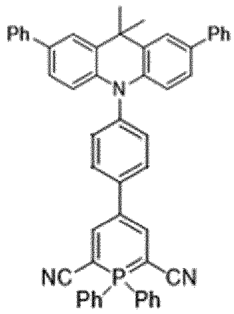

[Compound represented by formula (2)]

The light-emitting layer may be composed of only the compound represented by the formula (1), or may contain any other component. The other component includes a compound represented by the following formula (2). When the light-emitting layer contains both the compound represented by the formula (1) and the compound represented by the formula (2), the compound represented by the formula (2) effectively functions as a lasing sensitizer that transfers the energy produced by optical absorption to the compound represented by the formula (1), therefore improving the lasing characteristics of the laser device. Consequently, the compound represented by the formula (2) is useful as a lasing sensitizer.

Formula (2) $Z^1$-L-$Z^2$

In the formula (2), $Z^1$ and $Z^2$ each independently represent a substituted or unsubstituted diarylamino group, and the two aryl groups constituting the diarylamino group bond to each other directly or via a linking group. L represents a conjugated linking group that contains both a substituted or unsubstituted arylene group and a substituted or unsubstituted ethenylene group.

In L in the formula (2), the linking chain to bond $Z^1$ and $Z^2$ has a conjugated structure, and L is a linking group containing both a substituted or unsubstituted arylene group and a substituted or unsubstituted ethenylene group. Regarding the description and the preferred range of the aromatic ring that constitutes the substituted or unsubstituted arylene group in the conjugated linking group, reference may be made to the description of the aromatic ring that constitutes the aryl group described hereinabove relating to the formula (1). Specific examples of the arylene group include a phenylene group, and a structure of two or more phenylene groups linking to each other, such as a biphenyl-diyl group and a terphenyl-diyl group. Preferably, the conjugated inking group contains at least one of a phenylene group

and a biphenyl-diyl group. Also the conjugated linking group may contain a condensed ring formed by condensation of an aromatic ring such as a benzene ring and the arylene group.

The number of the benzene rings in L is preferably 1 or more, and can be, for example, 2 or more, 3 or more, and 4 or more, and can also be 30 or less, 20 or less, and 10 or less. Here, in the case where the conjugated linking group has a condensed ring that contains a benzene ring unit, the number of the benzene ring units (condensed benzene rings) is counted. For example, a naphthalene ring has two rings, and an anthracene ring has 3 rings.

The number of the ethenylene groups in L is is preferably 1 or more, and can be, for example, 2 or more, 3 or more, and 4 or more, and can also be 30 or less, 20 or less, and 10 or less.

Preferably, the conjugated linking group is so configured that a phenylene group or a biphenyl-diyl group and an ethenylene group are alternately positioned, and in the configuration, preferably, a phenylene group directly bonds to $Z^1$ and $Z^2$ (bonds thereto via a single bond).

The conjugated linking group may contain a divalent linking group having a heterocyclic aromatic ring, along with the substituted or unsubstituted arylene group and the substituted or unsubstituted ethenylene group therein. The heterocyclic aromatic ring as referred to herein is preferably a 5-membered ring or a 6-membered ring, and in this, the ring skeleton constituting hetero atom includes a nitrogen atom, an oxygen atom and a sulfur atom. A more preferred heterocyclic aromatic ring is a 6-membered ring that contains a nitrogen atom as a ring skeleton constituting hetero atom, or a 5-membered ring that contains an oxygen atom as a ring skeleton constituting hetero atom, and examples thereof include a pyridine ring, a pyridazine ring, a pyrimidine ring, a pyrazine ring, and furan ring. The conjugated linking group that L represents may have, for example, a structure formed of two or more benzofuran structure linking to each other, a structure formed of one or more benzofuran structures and one or more benzene rings linking to each other, a structure formed of one or more benzofuran structures and one or more ethenylene groups linking to each other, and a structure formed of one or more benzofuran structures, one or more benzene rings and one or more ethenylene groups linking to each other. The benzene ring and the furan ring that constitutes the conjugated linking group of L may be condensed, and the heterocyclic aromatic ring and the furan ring may also be condensed.

The conjugated inking group of L may have a structure formed of one or more groups, for example, selected from the following Group A linking to each other.

Group A

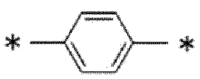
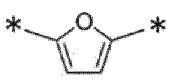
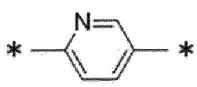
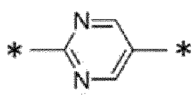
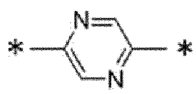

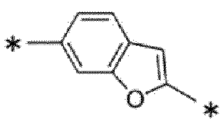
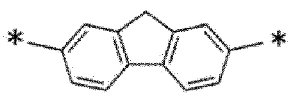
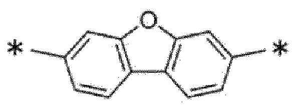
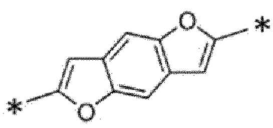

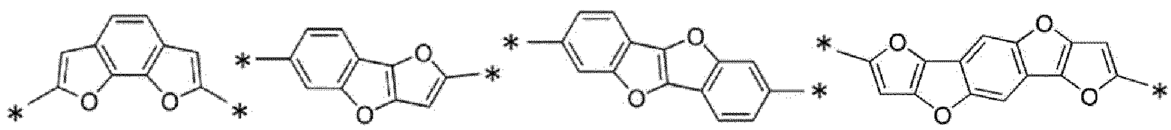

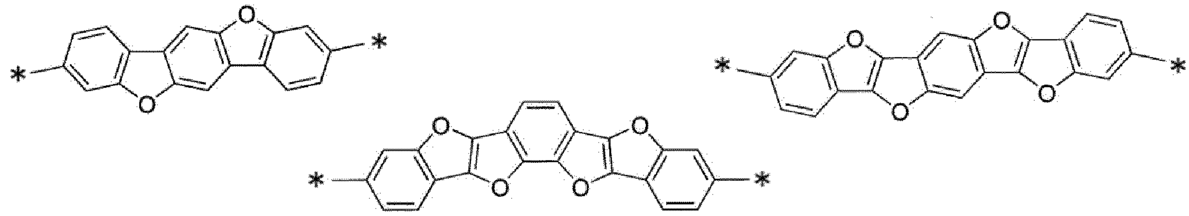

**[0054]** * indicates a linking position. A group that contains a benzofuran structure in the above-mentioned Group A

and a group that contains a fluorene structure can be such that at least one ring skeleton constituting atom of the benzene ring that constitutes the groups may be replaced with a nitrogen atom. Preferably, the number of the nitrogen atoms that is substituted with one ring is 1 or 2, and in the case where the number is 2, preferably, the two nitrogen atoms are so substituted that they do not directly bond to each other (they are not adjacent to each other). Among the groups of the Group A, the conjugated linking group may have a condensed ring formed by further condensation of a benzene ring that constitutes benzofuran with any other ring, a condensed ring formed by further condensation of a furan ring that constitutes benzofuran with any other ring, and a condensed ring formed by further condensation of both a benzene ring and a furan ring that constitute benzofuran with any other rings that differ from each other. The ring to be condensed may be any of an aromatic ring, a heterocyclic aromatic ring, a non-aromatic ring and a non-heterocyclic aromatic ring, and the number of the rings is not specifically limited. The number of the rings can be, for example, selected from a range of 2 to 30, or from a range of 2 to 15, or from a range of 2 to 8.

Also preferably, the conjugated linking group that L represents contains a structure represented by the following formula (12).

Formula (12)

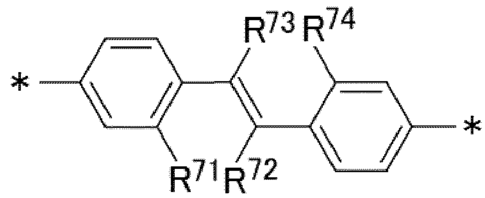

In the formula (12), $R^{71}$ to $R^{74}$ each independently represent a hydrogen atom or a substituent, and at least one pair of $R^{71}$ and $R^{72}$, and $R^{73}$ and $R^{74}$ each may bond to each other to form a linking group. The pair to constitute a linking group may be any one combination of $R^{71}$ and $R^{72}$, and $R^{73}$ and $R^{74}$, or may be both the two combinations. One example of the linking group to be formed by $R^{71}$ and $R^{72}$, or $R^{73}$ and $R^{74}$ bonding to each other is -O-.

**[0057]** * indicates a bonding position. The hydrogen atom bonding to the benzene ring in the formula (12) may be substituted with a substituent.

The hydrogen atom in the arylene group and the ethenylene group to constitute the conjugated linking group of L, and the heterocyclic aromatic ring, the furan ring and the benzofuran ring may be substituted with a substituent, or is preferably unsubstituted. Examples of the substituent include an alkyl group (having a carbon number of preferably 1 to 20, more preferably 1 to 6), an alkenyl group (having a carbon number of preferably 2 to 20, more preferably 2 to 6), an alkynyl group (having a carbon number of preferably 2 to 20, more preferably 2 to 6), an aryl group (having a carbon number of preferably 6 to 20, more preferably 6 to 14), and a heteroaryl group (of which the number of the ring skeleton constituting atoms is preferably 5 to 20, more preferably 5 to 14). The substituent that bonds to the arylene group, the heterocyclic aromatic ring, the furan ring and the benzofuran ring may bond to each other to form a cyclic structure. The cyclic structure includes an aromatic ring, a heterocyclic aromatic ring, a non-aromatic hydrocarbon ring, and a non-aromatic hetero ring. On the other hand, the substituents of the ethenylene group may bond to each other to form a cyclic structure, but do not form an aromatic ring or a heterocyclic aromatic ring. The cyclic structure to be formed can be a non-aromatic hydrocarbon ring or a non-aromatic hetero ring. The cyclic structure to be formed by the substituents bonding to each other is preferably a 5- to 7-membered ring, and more preferably a 5- or 6-membered ring.

$Z^1$ and $Z^2$ in the formula (2) each independently represent a substituted or unsubstituted diarylamino group, and the two aryl groups constituting the diarylamino group bond to each other directly or via a linking group. $Z^1$ and $Z^2$ may be the same as or different from each other, but are preferably the same. Also preferably, $Z^1$ and $Z^2$ each are independently a group represented by the following formula (13).

Formula (13)

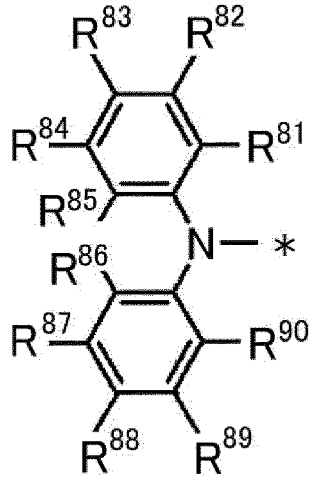

In the formula (13), $R^{81}$ to $R^{90}$ each independently represent a hydrogen atom or a substituent. $R^{85}$ and $R^{86}$ bond to each other to form a single bond or a linking group. $R^{81}$ and $R^{82}$, $R^{82}$ and $R^{83}$, $R^{83}$ and $R^{84}$, $R^{84}$ and $R^{85}$, $R^{86}$ and $R^{87}$, $R^{87}$ and $R^{88}$, $R^{88}$ and $R^{89}$, and $R^{89}$ and $R^{90}$ each may bond to each other to form a cyclic structure. * indicates a bonding position.

Regarding the substituent that $R^{81}$ to $R^{84}$, and $R^{87}$ to $R^{90}$ can have, reference may be made to the description relating to the substituent of the rings that constitutes the conjugated linking group of L. Regarding the cyclic structure that $R^{81}$ and $R^{82}$ form by bonding to each other, reference may be made to the description relating to the cyclic structure in the conjugated linking group of L.

Preferred examples of the group represented by the formula (13) are the groups of the formulae (7) to (11) where $L^{91}$, $L^{101}$, $L^{111}$, $L^{121}$, and $L^{141}$ are single bonds. Regarding the substituent that $R^{91}$ to $R^{150}$ can have and the cyclic structure to be formed by $R^{91}$ and $R^{92}$ and others bonding to each other, reference may be made to the description of the substituent and the cyclic structure relating to L in the formula (2).

Among the formulae (7) to (11), the formula (7) is preferred.

Examples of the compound represented by the formula (2) include the compound represented by the following formula (14).

Formula (14)

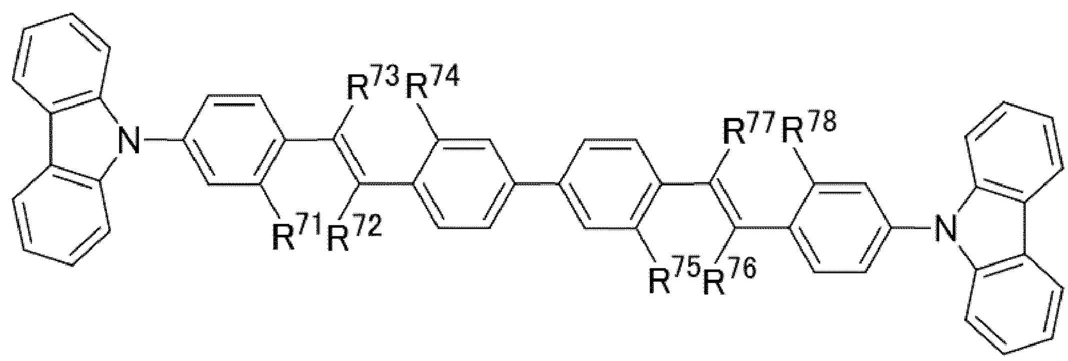

In the formula (14), $R^{71}$ to $R^{78}$ each independently represent a hydrogen atom or a substituent, at least one pair of $R^{71}$ and $R^{72}$, $R^{73}$ and $R^{74}$, $R^{75}$ and $R^{76}$, and $R^{77}$ and $R^{78}$ may bond to each other to form -O-. The hydrogen atom bonding to the benzene ring in the formula (14) may be substituted with a substituent, and two substituents may bond to each other to form a cyclic structure. Regarding the substituent, reference may be made to the description of the substituent of L in the formula (2). Regarding the cyclic structure, reference may be made to the description relating to the cyclic structure in the conjugated linking group of L in the formula (2).

Hereinunder a specific example of the compound represented by the formula (2) is shown. However, the compound represented by the genera formula (2) for use in the present invention should not be limitatively interpreted

by the specific example.

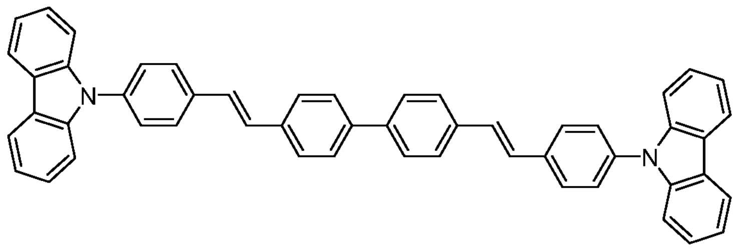

Compound B1 (BSBCz)

[Energy relationship between the compound represented by formula (1) and the compound represented by formula (2)]

From the viewpoint of effectively attaining the lasing sensitizing effect by the formula (2), preferably, the emission-excited singlet energy level of the compound represented by the formula (1) is lower than the emission-excited singlet energy level of the compound represented by the formula (2), and the emission-excited triplet energy level of the compound represented by the formula (1) is higher than the emission-excited triplet energy level of the compound represented by the formula (2). Namely, the compound represented by the formula (1) and the compound represented by the formula (2) preferably satisfy at least any of the following requirement (I) and requirement (II), and more preferably satisfy both the requirement (I) and the requirement (II).

Requirement (I): $E_{S1}<E(B)_{S1}$
Requirement (II): $E_{T1}>E(B)_{T1}$

In the requirement (I), $E_{S1}$ indicates the emission-excited singlet energy level of the compound represented by the formula (1); $E(B)_{S1}$ indicates the emission-excited singlet energy level of the compound represented by the formula (2). In the requirement (II), $E_{T1}$ indicates the emission-excited triplet energy level of the compound represented by the formula (1); $E(B)_{T1}$ indicates the emission-excited triplet energy level of the compound represented by the formula (2).

By satisfying the requirement (I), the excited singlet energy produced by optical absorption of the compound represented by the formula (2) can be effectively transferred to the photoexcited singlet energy level of the compound represented by the formula (1) by the Foerster transfer mechanism. Also by satisfying the requirement (II), the energy transfer from the photoexcited singlet energy level of the compound represented by the formula (2) to the photoexcited singlet energy level of the compound represented by the formula (1) can preferentially occur faster than the intersystem crossing from the excited singlet state to the excited triplet state of the compound represented by the formula (2). Accordingly with those, the compound represented by the formula (1) can be effectively transitioned to the photoexcited singlet energy state to thereby promote formation of inverted distribution. Also by satisfying the requirement (II), the photoexcited triplet state energy produced by intersystem crossing from the excited singlet state to the excited triplet state of the compound represented by the formula (1) can be transferred to the photoexcited triplet energy level of the compound represented by the formula (2) by the Dexter transfer mechanism. As a result, in the compound represented by the formula (1), the excited triplet state can be prevented from being in a high density and singlet-triplet annihilation can be thereby prevented. From the above, by satisfying the requirements (I) and (II), the emission efficiency can be high and the lasing characteristics can be thereby effectively improved. Here, in the case where each energy level includes plural vibration levels, preferably, at least the lowest vibration level satisfies the requirements (I) and (II), and more preferably all the vibration levels satisfy the requirements (I) and (II).

The difference between the emission-excited singlet energy level of the compound represented by the formula (2) and the emission-excited singlet energy level of the compound represented by the formula (1) ($E(B)_{S1}$ - $E_{S1}$) is preferably 0.01 to 2 eV, more preferably 0.01 to 1 eV, even more preferably 0.01 to 0.5 eV. The difference between the emission-excited triplet energy level of the compound represented by the formula (1) and the emission-excited triplet energy level of the compound represented by the formula (2) ($E_{T1}$ - $E(B)_{T1}$) is preferably 0.01 to 2 eV, more preferably 0.01 to 1 eV, even more preferably 0.01 to 0.5 eV.

The emission-excited singlet energy level ($E_{S1}$) and the emission-excited triplet energy level ($E_{T1}$) of the compound represented by the formula (1) for use in the present invention, and the emission-excited singlet energy level ($E(B)_{S1}$) and he emission-excited triplet energy level ($E(B)_{T1}$) of the compound represented by the formula (2) also for use in the present invention are measured in the following manner.

[1] Emission-excited singlet energy level ($E_{S1}$) of the compound represented by formula (1) and emission-excited singlet energy level ($E(B)_{S1}$) of the compound represented by formula (2)

A target compound to be measured is applied to an Si substrate in a thickness of 100 nm to prepare a sample. The fluorescent spectrum of the sample is measured at room temperature (300 K). By integrating the emission immediately after excitation light incidence until a few nanoseconds after the incidence, the fluorescent spectrum is plotted on a chart in which the emission intensity is on the vertical axis and the wavelength is on the horizontal axis. A tangent line is drawn to the rising of the fluorescent spectrum on the short wavelength side, and the wavelength value λedge [nm] at the intersection between the tangent line and the horizontal axis is read. The wavelength value is converted into an energy value according to the following conversion expression to calculate the emission-excited singlet energy level $E_{S1}$ or $E(B)_{S1}$.

Conversion Expression:

Emission-excited singlet energy level [eV] = 1239.85/λedge

For the measurement of the fluorescent spectrum, for example, a nitrogen laser (available from Lasertechnik Berlin, MNL200) is used as an excitation light source along with a streak camera (available from Hamamatsu Photonics K.K., C4334) as a detector. [2] Emission-excited triplet energy level ($E_{T1}$) of the compound represented by formula (1) and emission-excited triplet energy level ($E(B)_{T1}$) of the compound represented by formula (2)

The same sample as that for measurement of the emission-excited singlet energy level $E_{S1}$ is cooled to 30 [K], and the phosphorescence of the sample is measured using a streak camera. By integrating the emission component having a longer lifetime than that of the fluorescence, the phosphorescent spectrum is plotted on a chart in which the emission intensity is on the vertical axis and the wavelength is on the horizontal axis. A tangent line is drawn to the rising of the phosphorescent spectrum on the short wavelength side, and the wavelength value λedge [nm] at the intersection between the tangent line and the horizontal axis is read. The wavelength value is converted into an energy value according to the following conversion expression to calculate the emission-excited triplet energy level $E_{T1}$ or $E(B)_{T1}$.

Conversion Expression:

Emission-excited triplet energy level [eV] = 1239.85/λedge

The tangent line to the rising of the phosphorescent spectrum on the short wavelength side is drawn as follows. While moving on the spectral curve from the short wavelength side of the phosphorescent spectrum toward the maximum value on the shortest wavelength side among the maximum values of the spectrum, a tangent line at each point on the curve toward the long wavelength side is taken into consideration. With rising thereof (that is, with increase in the vertical axis), the inclination of the tangent line increases. The tangent line drawn at the point at which the inclination value has a maximum value is referred to as the tangent line to the rising on the short wavelength side of the phosphorescent spectrum.

The maximum point having a peak intensity of 10% or less of the maximum peak intensity of the spectrum is not included in the maximum value on the above-mentioned shortest wavelength side, and the tangent line drawn at the point which is closest to the maximum value on the shortest wavelength side and at which the inclination value has a maximum value is referred to as the tangent line to the rising on the short wavelength side of the phosphorescent spectrum.

[Layer configuration of laser device]

Using a compound represented by the formula (1) as a material for a light-emitting layer, a laser device excellent in lasing characteristics can be realized.

The laser device to which the present invention is applied may be an optically pumped laser device in which the light-emitting layer irradiated with excitation light can emit laser light, or may also be a current-excited laser device (organic semiconductor laser device) in which holes and electrons injected into the light-emitting layer are recombined to generate energy and to thereby emit a laser light. The optically pumped laser device is so configured as to have at least a light-emitting layer formed on a substrate. The current-excited laser device is so configured as to have at least an anode, a cathode, and an organic layer formed between the anode and the cathode. The organic layer contains at least a light-emitting layer, and can be formed of a light-emitting layer alone, or may have any one or more organic layers in addition to a light-emitting layer. Such other organic layers include a hole transport layer, a hole injection layer, an electron blocking layer, a hole blocking layer, an electron injection layer, an electron transport layer, and an exciton blocking layer. The hole transport layer may be a hole injection transport layer having a hole injection function, and the electron transport layer may be an electron injection transport layer having an electron injection function. A specific configuration example of a current-excited laser device is shown in Fig. 1. In Fig. 1, 1 is a substrate, 2 is an anode, 3 is a hole injection layer, 4 is a hole transport layer, 5 is a light-emitting layer, 6 is an electron transport layer, and 7 is a cathode. In the current-excited laser device, the laser light generated in the light-emitting layer can be taken outside via the anode, or can be taken outside via the cathode, or can also be taken outside via the anode and the cathode. The laser light generated in the light-emitting layer can be taken outside via the end section of the organic layer.

In the following, the constituent members and the layers of the current-excited laser device are described. The description of the substrate and the light-emitting layer also applies to the substrate and the light-emitting layer of an optically pumped laser device.

(Substrate)

The current-excited laser device of the present invention is preferably supported by a substrate. In the case where the current-excited laser device is so configured that the generated laser light is taken out from the substrate side, the substrate to be used therein is transparent to laser light, and in the device of the type, a transparent substrate of glass, transparent plastics or quartz is preferably used. On the other hand, in the case where the current-excited laser device is so configured that the laser light generated therein is taken out from the opposite side to the substrate, the substrate is not specifically limited, and in addition to the above-mentioned transparent substrates, other substrates of silicon, paper or cloth can also be used.

(Anode)

The anode in the current-excited laser device is preferably formed of, as an electrode material, a metal, an alloy, or an electroconductive compound, or a mixture thereof having a large work function (4 eV or more). Specific examples of the electrode material include a metal, such as Au, and an electroconductive transparent material, such as CuI, indium tin oxide (ITO), $SnO_2$, ZnO and TiN. A material that is amorphous and is capable of forming a transparent electroconductive film, such as IDIXO ($In_2O_3$-ZnO), may also be used. The anode may be formed in such a manner that the electrode material is formed into a thin film by such a method as vapor deposition or sputtering, and the film can be patterned to have a desired pattern by a photolithography method, or in the case where the pattern may not require high accuracy (for example, approximately 100 $\mu$m or more), the pattern may be formed with a mask having a desired shape on vapor deposition or sputtering of the electrode material. In alternative, in the case where a material capable of being coated, such as an organic electroconductive compound, is used, a wet film forming method, such as a printing method and a coating method, may be used.

In the case where the current-excited laser device is so configured that the laser light generated therein is to be taken out through the anode, the anode is required to be transparent to the laser light, and preferably has a laser light transmittance of more than 1%, more preferably more than 10%. Specifically, it is desirable that the above-mentioned electroconductive transparent material is used as the anode, or a thin film formed of a metal or an alloy to have a thickness of 10 to 100 nm is used as the anode.

In addition, a laminate film formed by laminating an anode formed of an electrode material such as a metal or an alloy exemplified in the section of (Cathode) given below, and a layer of a hole-injecting material such as molybdenum trioxide can also be used as the anode.

The sheet resistance of the anode is preferably several hundred Ω/sq or less. Though depending on the material thereof, the thickness of the anode may fall generally within a range of 10 to 1000 nm, preferably 10 to 200 nm.

(Cathode)

On the other hand, the cathode is formed of as an electrode material a metal (which is referred to as an electron-injecting metal), an alloy, or an electroconductive compound, or a mixture thereof having a smaller work function than that of the material for the anode. Specific examples of the electrode material include sodium, a sodiumpotassium alloy, magnesium, lithium, a magnesium-cupper mixture, a magnesium-silver mixture, a magnesium-aluminum mixture, a magnesium-indium mixture, an aluminum-aluminum oxide ($AL_2O_3$) mixture, indium, a lithium-aluminum mixture, aluminum, and a rare earth metal. Among these, a mixture of an electron-injecting metal and a second metal that is a stable metal having a larger work function than the electron-injecting metal, for example, a magnesium-silver mixture, a magnesium-aluminum mixture, a magnesium-indium mixture, an aluminum-aluminum oxide ($Al_2O_3$) mixture, a lithium-aluminum mixture, and aluminum, is preferred from the standpoint of the electron injection property and the durability against oxidation. The cathode may be produced by forming the electrode material into a thin film by such a method as vapor deposition or sputtering.

However, in the case where the current-excited laser device is so configured that the laser light generated therein is taken out via a cathode, the cathode needs to be transparent to the laser light and is preferably so planned that the laser light transmittance is more than 1%, more preferably more than 10%. Specifically, it is desirable that the cathode is formed of a thin film of the above-mentioned electrode material having a thickness of 10 to 100 nm.

In addition, a laminate film formed by laminating an electrode formed of an electroconductive transparent material such as indium tin oxide (ITO) exemplified in the section of (Anode) given above, and an organic layer containing an electron-injecting material such as cesium (Cs) can also be used as the cathode.

The sheet resistance of the cathode is preferably several hundred Ω/sq or less, and the thickness thereof may fall generally within a range of 10 nm to 5 $\mu$m, preferably 50 to 200 nm.

(Light-emitting layer)

The light-emitting layer is a layer in which holes and electrons injected from the anode and the cathode recombine to form excitons, and then emits laser light after formation of inverted distribution.

The light-emitting material (lasing material) in the light-emitting layer is generally one or more kinds selected from the compound group represented by the formula (1). The light-emitting layer may contain only the compound represented by the formula (1), or may contain any other material such as a lasing sensitizer and a host material. Preferred examples of the other material are compounds represented by the formula (2). When the light-emitting layer contains a compound represented by the formula (1) and a compound represented by the formula (2), the compound represented by the formula (2) effectively functions as a lasing sensitizer to promote the emission process of the compound represented by the formula (1), thereby improving the lasing characteristics of the compound of the formula (1). The light-emitting layer can contain one or more kinds selected from the compound group represented by the formula (2).

In the laser device of the present invention, the laser light generated is emitted by the compound represented by the formulas (1) contained as a light-emitting material therein. The laser light may be amplified spontaneous emission light or may also be simulated emission light as inductively emitted by external light. The light from the light-emitting layer may contain the light emitted from the compound represented by the formula (2).

In the case where the compound represented by the formula (2) is used, the content of the compound represented by the formula (1) in the light-emitting layer is 0.01 to 10% by weight, and the content of the compound represented by the formula (2) is preferably larger than the content of the compound represented by the formula (1). The content of the compound represented by the formula (1) in the light-emitting layer can be, for example, 0.1% by weight or more, or 0.5% by weight or more, and can be 90% by weight or less, or 50% by weight or less.

(Injection layer)

The injection layer is a layer that is provided between the electrode and the organic layer, for decreasing the driving voltage and enhancing the light emission luminance, and includes a hole injection layer and an electron injection layer, which may be provided between the anode and the light-emitting layer or the hole transport layer and between the cathode and the light emitting layer or the electron transport layer. The injection layer may be provided depending on necessity.

(Blocking layer)

The blocking layer is a layer that is capable of inhibiting charges (electrons or holes) and/or excitons present in the light-emitting layer from being diffused outside the light-emitting layer. The electron blocking layer may be disposed between the light-emitting layer and the hole transport layer, and inhibits electrons from passing through the light-emitting layer toward the hole transport layer. Similarly, the hole blocking layer may be disposed between the light-emitting layer and the electron transport layer, and inhibits holes from passing through the light-emitting layer toward the electron transport layer. The blocking layer may also be used for inhibiting excitons from being diffused outside the light-emitting layer. Thus, the electron blocking layer and the hole blocking layer each may also have a function as an exciton blocking layer. The term "the electron blocking layer" or "the exciton blocking layer" referred to herein is intended to include a layer that has both the functions of an electron blocking layer and an exciton blocking layer by one layer.

(Hole blocking layer)

The hole blocking layer has the function of an electron transport layer in a broad sense. The hole blocking layer has a function of inhibiting holes from reaching the electron transport layer while transporting electrons, and thereby enhances the recombination probability of electrons and holes in the light-emitting layer. As the material for the hole blocking layer, the material for the electron transport layer to be mentioned below may be used optionally.

(Electron blocking layer)

The electron blocking layer has the function of transporting holes in a broad sense. The electron blocking layer has a function of inhibiting electrons from reaching the hole transport layer while transporting holes, and thereby enhances the recombination probability of electrons and holes in the light-emitting layer.

(Exciton blocking layer)

The exciton blocking layer is a layer for inhibiting excitons generated through recombination of holes and

electrons in the light-emitting layer from being diffused to the charge transporting layer, and the use of the layer inserted enables effective confinement of excitons in the light-emitting layer, and thereby enhances the light emission efficiency of the device. The exciton blocking layer may be inserted adjacent to the light-emitting layer on any of the side of the anode and the side of the cathode, and on both the sides. Specifically, in the case where the exciton blocking layer is present on the side of the anode, the layer may be inserted between the hole transport layer and the light-emitting layer and adjacent to the light-emitting layer, and in the case where the layer is inserted on the side of the cathode, the layer may be inserted between the light-emitting layer and the cathode and adjacent to the light-emitting layer. Between the anode and the exciton blocking layer that is adjacent to the light-emitting layer on the side of the anode, a hole injection layer, an electron blocking layer and the like may be provided, and between the cathode and the exciton blocking layer that is adjacent to the light-emitting layer on the side of the cathode, an electron injection layer, an electron transport layer, a hole blocking layer and the like may be provided. In the case where the blocking layer is provided, preferably, at least one of the excited singlet energy and the excited triplet energy of the material used as the blocking layer is higher than the excited singlet energy and the excited triplet energy of the light-emitting layer, respectively, of the light-emitting material.

(Hole transport layer)

The hole transport layer is formed of a hole transport material having a function of transporting holes, and the hole transport layer may be provided as a single layer or plural layers.

The hole transport material has one of injection or transporting property of holes and blocking property of electrons, and may be any of an organic material and an inorganic material. Examples of known hole transport materials that may be used herein include a triazole derivative, an oxadiazole derivative, an imidazole derivative, a carbazole derivative, an indolocarbazole derivative, a polyarylalkane derivative, a pyrazoline derivative, a pyrazolone derivative, a phenylenediamine derivative, an arylamine derivative, an amino-substituted chalcone derivative, an oxazole derivative, a styrylanthracene derivative, a fluorenone derivative, a hydrazone derivative, a stilbene derivative, a silazane derivative, an aniline copolymer and an electroconductive polymer oligomer, particularly a thiophene oligomer. Among these, a porphyrin compound, an aromatic tertiary amine compound and a styrylamine compound are preferably used, and an aromatic tertiary amine compound is more preferably used.

(Electron transport layer}

The electron transport layer is formed of a material having a function of transporting electrons, and the electron transport layer may be a single layer or may be formed of plural layers.

The electron transport material (often also acting as a hole blocking material) may have a function of transmitting the electrons injected from a cathode to a light-emitting layer. The electron transport layer usable here includes, for example, nitrosubstituted fluorene derivatives, diphenylquinone derivatives, thiopyran dioxide derivatives, carbodiimides, fluorenylidenemethane derivatives, anthraquinodimethane and anthrone derivatives, oxadiazole derivatives, etc. Further, thiadiazole derivatives derived from the above-mentioned oxadiazole derivatives by substituting the oxygen atom in the oxadiazole ring with a sulfur atom, and quinoxaline derivatives having a quinoxaline ring known as an electron-attractive group are also usable as the electron transport material. Further, polymer materials prepared by introducing these materials into the polymer chain, or having these material in the polymer main chain are also usable.

(Resonator structure)

The current-excited laser device of the present invention may further have a resonator structure. "Resonator structure" is a structure for shuttling the light emitted by the light-emitting material through the light-emitting layer. With that, the light repeatedly runs back and forth through the light-emitting layer to cause stimulated emission, therefore providing a laser light having a higher intensity. The resonator structure is specifically composed of a pair of reflecting mirrors, in which one reflecting mirror preferably has a reflectance of 100%, while the other reflecting mirror preferably has a reflectance of 50 to 95%. By setting the reflectance of the other reflecting mirror relatively low, it becomes possible to make the laser light pass through the reflecting mirror and to take out the laser light. In the following, the reflecting mirror on the side through which the laser light is to be taken outside is referred to as "output mirror". The reflecting mirror and the output mirror may be provided separately from the layers and the members constituting the current-excited laser device, or in the device, the anode and the cathode may have a function as a reflecting mirror or the output mirror.

For example, in the case where the anode functions additionally as a reflecting mirror or an output mirror, preferably, the anode is formed of a metal film having a low visible light absorbance, having a high reflectance and having a relatively large work function (4.0 eV or more). Examples of such a metal film include a metal film of Ag, Pt or Au, or an alloy film containing such a metal. The reflectance and the transmittance of the anode can be controlled to be

a desired value by controlling the thickness of the metal film, for example, within a range of several tens nm or more.

In the case where the cathode functions additionally as a reflecting mirror or an output mirror, preferably, the cathode is formed of a metal film having a low visible light absorbance, having a high reflectance and having a relatively small work function. Examples of such a metal film include a metal film of Al or Mg, or an alloy film containing such a metal. The reflectance and the transmittance of the cathode can be controlled to be a desired value by controlling the thickness of the metal film, for example, within a range of several tens nm or more.

In the case where a reflecting mirror or an output mirror is provided separately from the above-mentioned layers and parts, preferably, a reflecting film is formed between the anode and the organic layer or between the substrate and the anode so as to function as a reflecting mirror or an output mirror.

In the case where a reflecting mirror or an output mirror is provided between the anode and the organic layer, preferably, the material to be used for the mirror is an electroconductive material having a small visible light absorbance, having a high reflectance, and having a large work function (work function of 4.0 eV or more). Specifically, a metal film of a metal such as Ag, Pt or Au, or an alloy containing such a metal can be used as a reflecting mirror or an output mirror. The reflectance and the transmittance of the reflecting mirror or the output mirror can be controlled to be a desired value by controlling the thickness of the metal film, for example, within a range of several tens nm or more. Here, in the case where such a reflecting mirror or output mirror is provided between the anode and the organic layer, the material for the anode need not to have a large work function, and a known electrode material can be widely used for the anode.

In the case where a reflecting mirror or an output mirror is provided between the substrate and the anode, preferably, the material for the mirror is one having a small visible light absorbance and a high reflectance. Specifically, a metal film of a metal such as Al, Ag or Pt, or an alloy containing such a metal, or a laminate film formed by laminating a Ti film on an alloy film of Al and Si, or a dielectric multilayer film formed by alternately layering silicon oxide and titanium oxide can be used as a reflecting mirror or an output mirror. Among these, the reflectance and the transmittance of the metal film can be controlled to be a desired value by controlling the thickness of the metal film, for example, within a range of several tens nm or more. The reflectance and the transmittance of the dielectric multilayer film can be controlled to be a desired value by controlling the thickness of silicon oxide and titanium oxide and the layering number thereof.

Examples of the combination of a reflecting mirror and an output mirror include a combination where an output mirror serves as an anode and a reflecting mirror serves as a cathode, a combination where an output mirror is a reflecting film arranged between the anode and the organic layer or between the substrate and the anode, and a reflecting mirror serves as a cathode, a combination where a reflecting mirror serves as an anode and an output mirror serves as a cathode, and a combination where a reflecting mirror is a reflecting film arranged between the anode and the organic layer or between the substrate and the anode, and an output mirror serves as a cathode.

In such a resonator structure, preferably, the device layer configuration is so planned that the total optical thickness (the total of values each calculated by multiplying the film thickness by the refractive index of each layer) of the layers existing between the reflecting mirror and the output mirror could be the integral multiple of the half wave of the laser light. With that, a standing wave can be formed between the reflecting mirror and the output mirror for light amplification to give a laser light having a higher intensity.

In the above-mentioned resonator structure, the laser light is made to run back and forth in the direction vertical to the main plane of the substrate, but the resonator structure in the present invention may also be so configured that the laser light is made to run back and forth in the direction horizontal to the main plane of the substrate. In these resonator structures, the end section of the organic layer may act as a reflecting mirror or an output mirror by utilizing reflection by the refractive index difference between the organic layer and air. Near the light-emitting layer, gratings may be provided at a grating space of $\lambda/2n$ (where $\lambda$ is a wavelength of light, and n is an integer of 1 or more) so that the light generated in the light-emitting layer can be periodically reflected by the grating space of the gratings. With that, a single longitudinal mode can be realized, and a laser light with good monochromaticity can be emitted from the end section of the organic layer.

The current-excited laser device mentioned above emits a laser light by applying a current of more than a threshold current density between the anode and the cathode. In the laser device of the present invention regarding the case, the light-emitting layer contains a compound represented by the formula (1) therefore realizing excellent lasing characteristics. Further, when the layer further contains a compound represented by the formula (2), the lasing characteristics can be further improved.

In producing the current-excited laser device of the present invention, not only a compound represented by the formula (1) and a compound represented by the formula (2) are used in the light-emitting layer, but also these compound can be used in any other layer than the light-emitting layer. In such a case, the compound represented by the formula (1) and the compound represented by the formula (2) used in the light-emitting layer, and the compound represented by the formula (1) and the compound represented by the formula (2) used in the other layer than the light-emitting layer may be the same or different. For example, the compound represented by the formula (1) and the compound represented by the formula (2) can also be used in the injection layer, the blocking layer, the hole blocking layer, the electron blocking layer, the exciton blocking layer, the hole transport layer and the electron transport layer mentioned above. Methods for

forming these layers are not specifically limited, and the layers may be formed by any of a dry process or wet process.

<Compound represented by formula (3)>

Among the compounds represented by the formula (1), compounds represented by the formula (3) are novel compounds.

Formula (3)

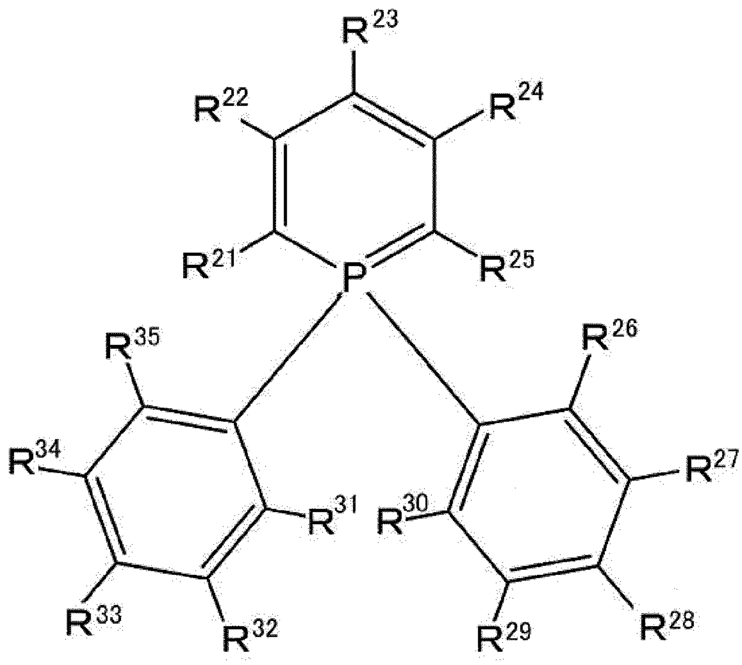

In the formula (3), $R^{21}$ and $R^{25}$ each independently represent a substituent having a positive Hammett's σp value, $R^{23}$ represents a substituent, $R^{22}$, $R^{24}$, and $R^{26}$ to $R^{35}$ each independently represent a hydrogen atom or a substituent. However, when $R^{21}$ and $R^{25}$ each are a cyano group, $R^{23}$ is a substituted aryl group, or a substituted or unsubstituted heteroaryl group.

Regarding the description, the preferred range and the specific examples of $R^{21}$, $R^{22}$, and $R^{24}$ to $R^{35}$ in the formula (3), reference may be made to the description relating to $R^1$, $R^2$, and $R^4$ to $R^{15}$ in the formula (1). Regarding the description, the preferred range and the specific examples of $R^{23}$ in the formula (3), reference may be made to the description, the preferred range and the specific examples of the substituent in $R^2$ to $R^4$ in the formula (1), and above all, it is preferable that $R^{23}$ is a substituted or unsubstituted aryl group, a substituted or unsubstituted heteroaryl group, $R^{36}$CO- ($R^{36}$ represents a hydrogen atom or a substituent), or a halogen atom. For example, for $R^{23}$, a substituted aryl group can be specifically selected. Also for $R^{23}$, a halogen atom can be selected. Especially for $R^{23}$, $R^{36}$CO- can be selected.

The compound represented by the formula (3) is useful as a material for the light-emitting layer of the laser device. Further, the compound of the formula (3) where $R^{23}$ is a halogen atom is useful as a material in synthesizing a compound having any other substituent than a halogen atom as $R^{23}$. In particular, a compound where $R^{21}$ and $R^{25}$ each are a cyano group and $R^{23}$ is a halogen atom is useful as a material for synthesis of a compound represented by the following formula (4). Regarding the method for synthesis of a compound of the formula (4), in which a compound of the formula (3) where $R^{21}$ and $R^{25}$ each are a cyano group and $R^{23}$ is a halogen atom is used as a material for the synthesis, reference may be made to the description in the section of <Production method for the compound represented by genera formula (4)> given below.

<Production method for the compound represented by formula (4)>

Next, a production method for the compound represented by the following formula (4) is described.

Formula (4)

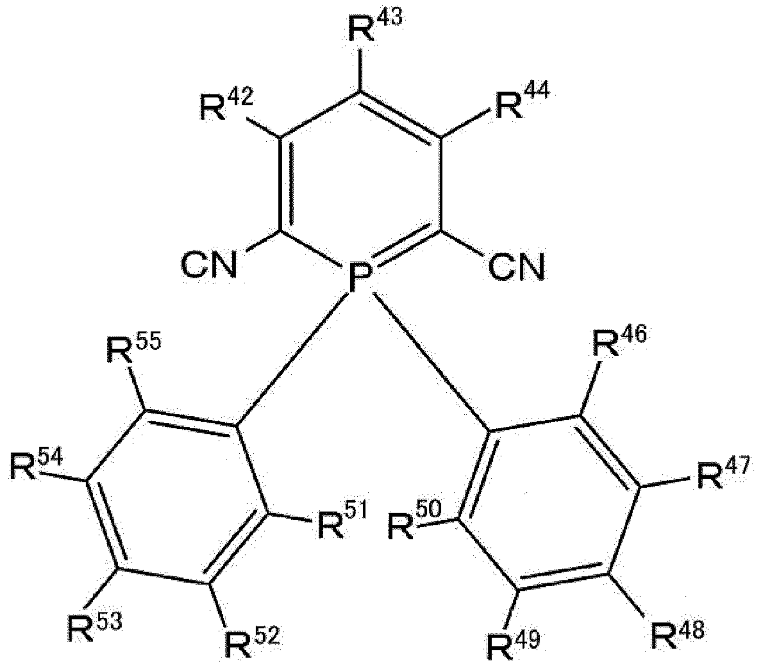

In the formula (4), $R^{43}$ represents a substituted aryl group, or a substituted or unsubstituted heteroaryl group, and $R^{42}$, $R^{44}$, and $R^{46}$ to $R^{55}$ each independently represent a hydrogen atom or a substituent.

Regarding the description, the preferred range and the specific examples of $R^{42}$, $R^{44}$, and $R^{46}$ to $R^{55}$ in the formula (4), reference may be made to the description relating to $R^2$, $R^4$, and $R^6$ to $R^{15}$ in the formula (1). Regarding the description, the preferred range, the specific examples and the substituent of the aromatic ring of the aryl group and the heterocyclic aromatic ring of the heteroaryl group that $R^{43}$ in the formula (4) can have, reference may be made to the description relating to the substituted aryl group or the substituted or unsubstituted heteroaryl group in the description relating to $R^3$ in the formula (1).

In the production method of the present invention, the compound represented by the formula (4) is produced through a step of halogenating the 4-position of a 2,6-dicyano-1,1-diphenylphosphinine in which the 4-position is unsubstituted and the other positions may be substituted, followed by a step of reacting the resulting intermediate with a compound represented by $R^{43}$-H. The reaction of the production method of the present invention is shown below.

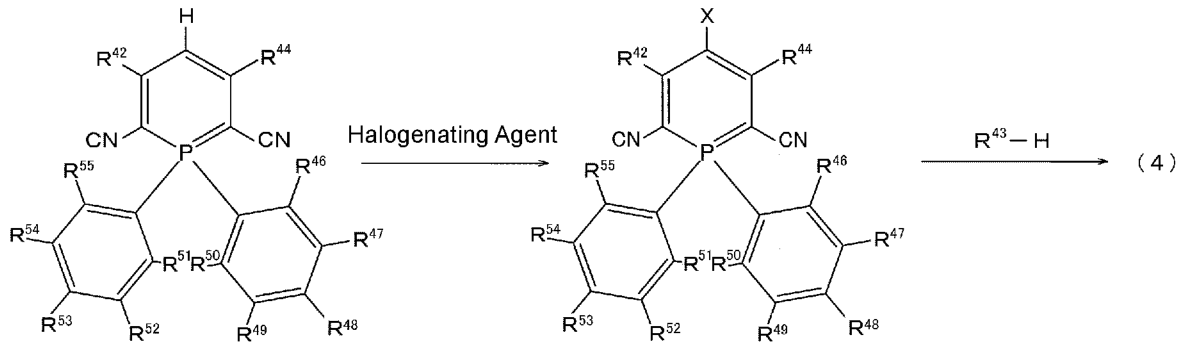


Regarding the description of $R^{42}$, $R^{44}$, and $R^{46}$ to $R^{55}$ in the above reaction formula, reference may be made to the corresponding description in the formula (4).

X represents a halogen atom, including a fluorine atom, a chlorine atom, a bromine atom and an iodine atom, and is preferably a chlorine atom, a bromine atom or an iodine atom, more preferably a bromine atom. As a brominating agent for introducing a bromine atom, for example, N-bromosuccinimide can be used.

To the above reaction, applied are a selective electrophilic substitution reaction at the 4-position of a phosphinine and a known coupling reaction such as a Suzuki coupling reaction, and for the reaction, any known reaction condition can be appropriately selected and used.

<Lasing sensitizer>

Next, the lasing sensitizer of the present invention is described.

The lasing sensitizer of the present invention contains a compound represented by the formula (2).

Regarding the structure represented by the formula (2) and the description of the formula (2), reference may be made to the description in the section of [Compound represented by formula (2)].

The compound represented by the formula (2) is characterized in that it can readily transfer the excited singlet energy obtained in optical absorption to a light-emitting material and that it can readily receive the excited triplet energy generated by intersystem crossing in a light-emitting material. Consequently, the compound represented by the formula (2) acts on a light-emitting material in such a manner that the compound promotes transfer to a photoexcited singlet state in a light-emitting material and formation of inverted distribution therein, and inhibits singlet-triplet annihilation in a light-emitting material, thereby improving the lasing characteristics of the light-emitting material. Consequently, the compound represented by the formula (2) is useful as a lasing sensitizer.

<Laser device (second laser device)>

Next, the second laser device of the present invention is described.

The laser device (second laser device) of the present invention is a laser device having a light-emitting layer that contains a lasing sensitizer and a light-emitting material. Here, the lasing sensitizer contains a compound represented by the formula (2). Regarding the structure represented by the formula (2) and the description of the formula (2), reference may be made to the description in the section of [Compound represented by formula (2)], and regarding the effect of the lasing sensitizer containing the compound represented by the formula (2), reference may be made to the description in the section of [Compound represented by formula (2), and the description in the section of <Lasing sensitizer> given hereinabove.

In the second laser device, the emission-excited singlet energy level of the light-emitting material is lower than the emission-excited singlet energy level of the lasing sensitizer, and the emission-excited triplet energy level of the light-emitting material is higher than the emission-excited triplet energy level of the lasing sensitizer. With that, the excited singlet energy produced by optical absorption of the compound represented by the formula (2) can be effectively transferred to the emission-excited singlet energy level of the light-emitting material by the Foerster transfer mechanism. Also, the excited triplet energy produced by intersystem crossing in the light-emitting material can be transferred to the emission-excited triplet energy level of the compound represented by the formula (2) by the Dexter transfer mechanism. Accordingly, in the laser device, the lasing sensitizer can function more effectively and can improve the lasing characteristics of the device. Here, regarding the evaluation of the mechanism, reference may be made to the description in the section of [Energy relationship between the compound represented by formula (1) and the compound represented by formula (2)] in which "the compound represented by formula (1)" is replaced with "light-emitting material".

The light-emitting material is a compound capable of generating amplified spontaneous emission light or simulated emission light, and any such compound that satisfies the above-mentioned energy relationship can be used here with no limitation.

Regarding the layer configuration of the second laser device, reference may be made to the section of "Layer configuration of laser device" given hereinabove, in which "the compound represented by formula (1)" is replaced with "light-emitting material".

Examples

The features of the present invention will be described more specifically with reference to Examples given below. The materials, processes, procedures and others shown below may be appropriately modified unless they deviate from the substance of the invention. Accordingly, the scope of the invention is not construed as being limited to the specific examples shown below. Hereinunder the light emission characteristics were evaluated using a spectrofluorometer (available from JASCO Corporation, FP-8600), an absolute PL quantum yield meter (available from Hamamatsu Photonics K.K., C11347-01), and a multichannel spectrometer (available from Hamamatsu Photonics K.K., PMA-12).

[1] Synthesis of compound represented by formula (1)

(Synthesis Example 1) Synthesis of Compound 1

[1-1] Synthesis step for bis(cyanomethyl)diphenylphosphonium chloride (Intermediate 1)

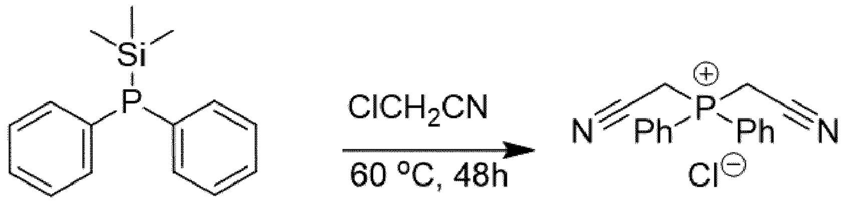


Intermediate 1

Diphenyltrimethylsilyl phosphine (11.55 g, 44.7 mmol) was dissolved in chloroacetonitrile (16.8 g, 5.0 equivalent) and stirred at 60°C for 48 hours. The mixture was cooled, and the precipitated deposit was separated by filtration to give a yellow solid. The yellow solid was washed with chloroform and diethyl ether, and dried under reduced pressure at 70°C for 2 hours to give a white solid of Intermediate 1. Yield: 9.84 g, 73%.

[1-2] Synthesis step for N,N'-diphenyl-1,3-diiminopropane (Intermediate 2)]

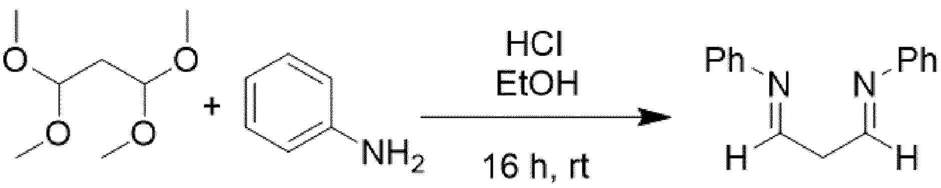


Intermediate 2

1,1,3,3-Tetramethoxypropane (5.01 g, 30.5 mmol) and aniline (5.80 g, 62.3 mmol) were dissolved in ethanol (60 mL) and cooled to 0°C. Concentrated hydrochloric acid (6 mL) was added to the mixture, then restored to room temperature, and stirred for 16 hours. The reaction liquid was concentrated under reduced pressure, and the precipitated deposit was separated by filtration to give a yellow solid. The yellow solid was recrystallized with methanol to give a yellow solid of Intermediate 2. Yield: 6.12 g, 90%.

[1-3] Synthesis step for 2,6-dicyano-1,1-diphenyl-$\lambda^5\sigma^4$-phosphinine (Compound 1)

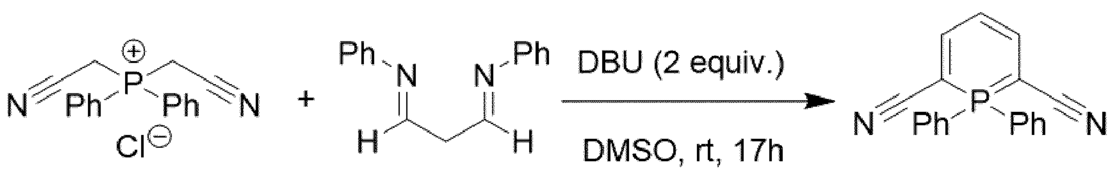


Intermediate 1 Intermediate 2 Compound 1

Intermediate 1 (2.11 g, 7.02 mmol) and Intermediate 2 (1.87 g, 8.41 mmol, 1.2 equivalent) were dissolved in dimethyl sulfoxide (35 mL), and diazabicycloundecene (2.16 g, 14.2 mmol, 2.0 equivalent) was added, and then stirred at room temperature for 17 hours. IN hydrochloric acid (20 mL) was added to the reaction liquid, and stirred for 15 minutes, and then extracted three times with ethyl acetate. The three organic layers were combined into one and washed with brine, then dried with sodium sulfate, and thereafter the solvent was evaporated away under reduced pressure. The residue was purified through silica gel chromatography using a mixed solvent of ethyl acetate/chloroform/n-hexane = 1/1/3 as an eluent to give a yellow solid of Compound 1. Yield: 1.89 g, 90%.

$^1$H NMR (500 MHz, DMSO-D$_6$) $\delta$ 5.51 (td, J = 8.5, 2.0 Hz, 1H), 7.62-7.66 (m, 5H), 7.68-7.70 (d, J = 10.0 Hz, 1H), 7.79-7.83 (m, 6H); $^{13}$C NMR (125 MHz, DMSO-D$_6$) $\delta$ 56.81, 57.67, 103.49, 103.59, 119.03, 119.13, 125.43, 126.16,

130.48, 130.58, 132.50, 132.59, 134.49, 134.52, 147.35; $^{31}P$ NMR (202 MHz, DMSO-$D_6$) $\delta$ 11.70; MS (ASAP): m/z calcd for $C_{19}H_{13}N_2P$: 300.0816 ([M]+1); found. 301.17.

(Synthesis Example 2) Synthesis of Compound 2

[2-1] Synthesis step for 4-bromo-2,6-dicyano-1,1-diphenyl-$\lambda^5\sigma^4$-phosphinine (Intermediate 3)

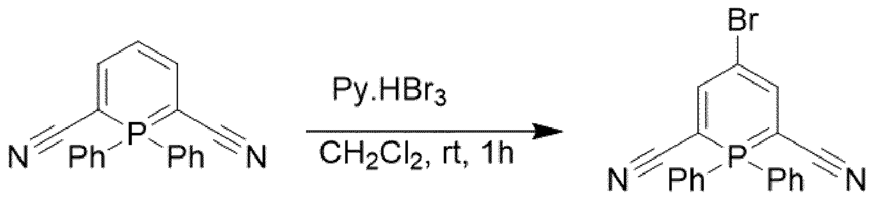


Compound 1 Intermediate 3

Compound 1 (1.05 g, 3.5 mmol) was dissolved in dichloromethane (17.5 mL), and then pyridinium bromide perbromide (1.12 g, 3.5 mmol, 1.0 equivalent) was added, and stirred at room temperature for 1 hour. Water was added to the mixture, and extracted three times with chloroform. The three organic layers were combined into one and washed with 1 M hydrochloric acid and brine, then dried with sodium sulfate, and thereafter concentrated under reduced pressure. The resultant residue was roughly purified through silica gel column chromatography using chloroform as an eluent and recrystallized from a mixed solvent of chloroform and diethyl ether to give a red-orange solid of Intermediate 3. Yield: 1.17 g, 88%.

[2-2] Synthesis step for 4-(4-dihenylamino)phenyl)-1,1-diphenyl-1$\lambda^5$-phosphinine-2,6-dicarbonitrile (Compound 2)

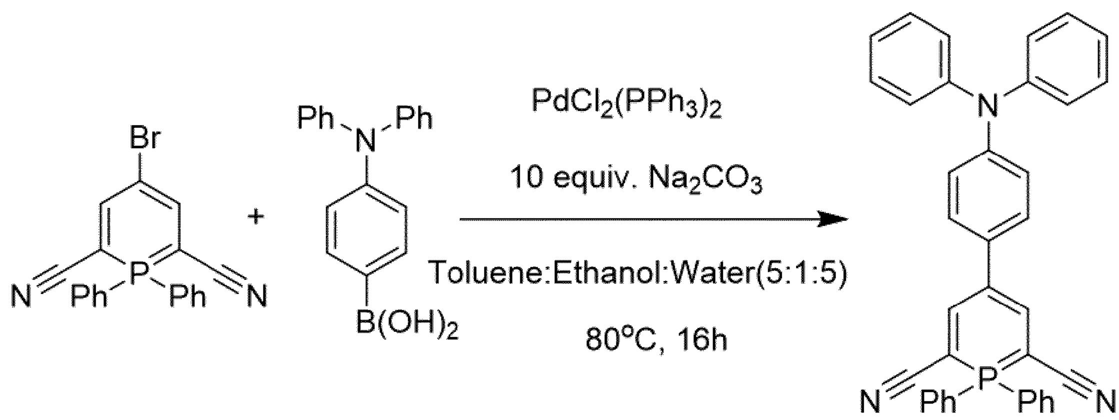


Intermediate 3 Compound 2

Intermediate 3 (0.377 g, 1 mmol, 1.0 equivalent), (4-(diphenylamino)phenyl)boronic acid (0.433 g, 1.5 mmol, 1.5 equivalent), bis(triphenylphosphine)palladium(II) dichloride (28 mg, 0.04 mmol, 4 mol%) and sodium carbonate (1.05 g, 10 mmol, 10 equivalent) were dissolved in a mixed solvent of toluene/ethanol/water = 10/2.5/10, and refluxed at 85°C for 24 hours. The mixture was cooled down to room temperature, then water was added, and extracted four times with chloroform. The four organic layers were combined into one, washed with brine, dried with sodium sulfate, and the solvent was evaporated away under reduced pressure. The resultant residue was purified through silica gel column chromatography using a mixed solvent of ethyl acetate/n-hexane = 1/3 as an eluent to give a red solid of Compound 2. Yield: 0.37 g, 68%.

$^1H$ NMR (500 MHz, DMSO-$D_6$) $\delta$ 6.94-6.95 (d, *J*= 5.0 Hz, 2 H), 6.98-6.70 (d, *J* = 10.0 Hz, 4H), 7.01-7.04 (t, *J* = 7.5 Hz, 2H), 7.27-7.30 (t, *J* =7.5 Hz, 4H), 7.40-7.42 (d, *J* = 5.0 Hz, 2H), 7.67-7.87 (m, 10H), 7.99 (s, 1H), 8.05 (s, 1H);

$^{13}C$ NMR (125 MHz, DMSO-$D_6$) δ 58.29, 59.15, 115.61, 115.69, 118.99, 119.08, 123.26, 124.02, 124.55, 124.77, 125.50, 126.20, 129.97, 130.55, 130.66, 132.67, 132.76, 134.29, 134.69, 145.51, 145.76, 147.70; $^{31}P$ NMR (202 MHz, DMSO-$D_6$) δ 9.43; MS(ASAP): *m/z* calcd. for $C_{37}H_{26}N_3P$: 543.1864 ([M]+1); found. 544.40.

(Synthesis Example 3) Synthesis of Compound 3

In the same manner as in Synthesis Example 2 except that in the step [2-2], (9-phenyl-9H-carbazol-3-yl)boronic acid was used in place of (4-(diphenylamino)phenyl)boronic acid, a red solid of Compound 3 was produced. Yield: 0.40 g, 74%.

$^{1}H$ NMR (500 MHz, DMSO-$D_6$) δ 7.27-7.30 (t, *J* = 7.5 Hz, 1H), 7.32-7.34 (d, *J* = 10.0 Hz, 1H), 7.37-7.39 (d, *J*= 10.0 Hz, 1H), 7.41-7.44 (t, *J*= 7.5 Hz, 1H), 7.52-7.57 (m, 2H), 7.62-7.63 (t, *J* =5.0 Hz, 2H), 7.71-7.72 (d, *J* = 5.0 Hz, 2H), 7.73-7.88 (m, 10H), 8.14 (s, 1H), 8.19 (s, 1H), 8.27-8.29 (d, *J* = 10.0 Hz, 1 H), 8.40 (s, 1H); $^{13}C$ NMR (125 MHz, DMSO-$D_6$) δ 58.05, 58.91, 110.11, 116.91, 116.99, 117.24, 119.20, 119.30, 120.49, 121.22, 123.43, 123.74, 124.17, 125.01, 125.75, 126.79, 127.02, 128.06, 130.57, 130.68, 132.20, 132.67, 132.76, 134.66, 137.40, 139.13, 140.97, 146.17; $^{31}P$ NMR (202 MHz, DMSO-$D_6$) δ 9.51; MS(ASAP): *m/z* calcd. for $C_{37}H_{24}N_3P$: 541.1708 ([M]+1); found. 542.24.

(Synthesis Example 4) Synthesis of Compound 5

In the same manner as in Synthesis Example 2 except that in the step [2-2], (4-(3,6-dimethyl-9H-carbazol-9-yl)phenyl)boronic acid was used in place of (4-(diphenylamino)phenyl)boronic acid, a yellow-orange solid of Compound 5 was produced. Yield: 0.40 g, 71%.

$^{1}H$ NMR (500 MHz, DMSO-$D_6$) δ 2.48 (s, 6H), 7.22-7.24 (d, *J*= 10.0 Hz, 2H), 7.24-7.28 (t, *J*= 10.0 Hz, 2H), 7.51-7.53 (d, *J* = 10.0 Hz, 2H), 7.72-7.75 (t, *J* =7.5 Hz, 2H), 7.74-7.76 (d, *J*= 10.0 Hz, 4H), 7.82-7.89 (m, 6H), 7.98 (s, 2H), 8.17 (s, 1H), 8.23 (s, 1H); $^{13}C$ NMR (125 MHz, DMSO-$D_6$) δ 21.49, 58.81, 59.66, 109.78, 115.15, 115.23, 118.91, 119.01, 120.68, 123.22, 124.65, 125.38, 126.61, 126.88, 127.78, 129.12, 130.60, 130.71, 132.74, 132.83, 134.77, 135.29, 138.42, 139.09, 146.32; $^{31}P$ NMR (202 MHz, DMSO-$D_6$) δ 9.38; HRMS(ASAP): *m/z* calcd. for $C_{39}H_{28}N_3P$: 569.2021 ([M]+1); found. 570.40.

(Synthesis Example 5) Synthesis of Compound 7

In the same manner as in Synthesis Example 2 except that in the step [2-2], ((3-(3,6-dimethyl-9H-carbazol-9-yl)phenyl)boronic acid was used in place of (4-(diphenylamino)phenyl)boronic acid, a yellow solid of Compound 7 was produced. Yield: 0.38 g, 67%.

$^{1}H$ NMR (500 MHz, DMSO-$D_6$) δ 2.48 (s, 6H), 7.22-7.24 (d, *J*= 10.0 Hz, 2H), 7.30-7.32 (t, *J* = 10.0 Hz, 2H), 7.36-7.38 (d, *J* = 10.0 Hz, 1H), 7.57-7.62 (m, 2H), 7.69-7.72 (t, *J* = 7.5 Hz, 2H), 7.73 (m, 3H), 7.79.7.87 (m, 6H), 7.97 (s, 2H), 8.19 (s, 1H), 8.25 (s, 1H); $^{13}C$ NMR (125 MHz, DMSO-$D_6$) δ 21.50, 58.77, 59.63, 110.05, 114.94, 115.02, 118.86, 118.96, 120.56, 122.98, 123.17, 123.90, 123.96, 124.66, 125.39, 127.76, 129.01, 130.56, 130.66, 130.73, 132.73, 132.82, 134.73, 138.26, 139.19, 141.53, 146.55; $^{31}P$ NMR (202 MHz, DMSO-$D_6$) δ 9.34; MS(ASAP): *m/z* calcd. for $C_{39}H_{28}N_3P$: 569.2021 ([M]+1); found. 570.31.

(Synthesis Example 6) Synthesis of Compound 8

In the same manner as in Synthesis Example 2 except that in the step [2-2], (9,9-dimethyl-9H-fluoren-2-yl)boronic acid was used in place of (4-(diphenylamino)phenyl)boronic acid, an orange solid of Compound 8 was produced. Yield: 0.34 g, 70%.

$^{1}H$ NMR (500 MHz, DMSO-$D_6$) δ 1.46 (s, 6H), 7.26-7.33 (m, 2H), 7.45-7.47 (d, *J*= 10.0 Hz, 1H), 7.51-7.52 (d, *J*= 10.0 Hz, 1H), 7.70-7.88 (m, 13H), 8.16 (s, 1H), 8.22 (s, 1H); $^{13}C$ NMR (125 MHz, DMSO-$D_6$) δ 27.33, 47.00, 58.45, 59.31, 116.33, 116.41, 119.06, 119.15, 119.61, 120.34, 120.76, 123.13, 123.93, 124.81, 125.54, 127.39, 127.45, 130.57, 130.67, 132.70, 132.79, 134.70, 136.61, 138.77, 138.91, 146.21, 153.92, 154.48; $^{31}P$ NMR (202 MHz, DMSO-$D_6$) δ 9.31; MS(ASAP): *m/z* calcd. for $C_{34}H_{25}N_2P$: 492.1755 ([M]+1); found. 493.33.

(Synthesis Example 7) Synthesis of Compound 9

In the same manner as in Synthesis Example 2 except that in the step [2-2], (9,9-diphenyl-9H-fluoren-2-yl)boronic acid was used in place of (4-(diphenylamino)phenyl)boronic acid, an orange solid of Compound 9 was produced. Yield: 0.46 g, 75%.

$^{1}H$ NMR (500 MHz, DMSO-$D_6$) δ 7.17-7.19 (d, *J* = 10.0 Hz, 4H), 7.21-7.23 (d, *J* = 10.0 Hz, 2H), 7.24-7.29 (m, 5H), 7.36-7.39 (m, 2H), 7.52-7.54 (d, *J*= 10.0 Hz, 1H), 7.64-7.71 (m, 5H), 7.77-7.91 (m, 8H), 8.07 (s, 1H), 8.13 (s, 1H);

$^{13}C$ NMR (125 MHz, DMSO-$D_6$) δ 58.61, 59.47, 65.58, 115.72, 115.80, 118.96, 119.06, 120.77, 121.26, 122.20, 124.69, 124.79, 125.42, 126.52, 127.04, 127.85, 128.12, 128.34, 128.77, 130.53, 130.63, 132.73, 132.82, 134.68, 137.67, 139.34, 139.86, 146.22, 146.27, 151.09, 151.84; $^{31}P$ NMR (202 MHz, DMSO-$D_6$) δ 9.30; MS(ASAP): *m/z* calcd. for $C_{44}H_{29}N_2P$: 616.2068 ([M]+1); found. 617.38.

(Synthesis Example 8) Synthesis of Compound 10

In the same manner as in Synthesis Example 2 except that in the step [2-2], 9,9'-spirobi[9H-fluorene]-2-boronic acid was used in place of (4-(diphenylamino)phenyl)boronic acid, an orange solid of Compound 10 was produced. Yield: 0.36 g, 59%.

$^1H$ NMR (500 MHz, DMSO-$D_6$) δ 6.51-6.52 (d, *J* = 5.0 Hz, 1H), 6.61-6.63 (d, *J* = 10.0 Hz, 2H), 6.75 (s, 1H), 7.06-7.09 (t, *J*= 7.5 Hz, 1H), 7.12-7.15 (t, *J* = 7.5 Hz, 2H), 7.35-7.39 (t, *J* = 7.5 Hz, 1H), 7.39-7.42 (t, *J* = 7.5 Hz, 2H),7.52-7.54 (d, *J* = 10.0 Hz, 1H), 7.61-7.63 (d, *J* = 10.0 Hz, 2H), 7.64-7.66 (d, *J* = 10.0 Hz, 2 H), 7.73-7.83 (m, 7H), 7.86 (s, 1H), 7.97-7.99 (d, *J* = 10.0 Hz, 2H), 8.01-8.02 (d, *J* = 5.0 Hz, 2H); $^{13}C$ NMR (125 MHz, DMSO-$D_6$) δ 58.56, 59.42, 66.00, 115.51, 115.60, 118.82, 118.91, 119.90, 120.77, 121.04, 121.27, 123.71, 123.98, 124.66, 125.32, 125.39, 128.04, 128.32, 128.35, 128.44, 130.46, 130.56, 132.70, 132.80, 134.62, 139.60, 139.67, 141.38, 141.83, 146.10, 148.78, 149.08, 149.23; $^{31}P$ NMR (202 MHz, DMSO-$D_6$) δ 9.41; MS(ASAP): *m/z* calcd. for $C_{44}H_{27}N_2P$: 614.1912 ([M]+1); found. 615.39.

(Synthesis Example 9) Synthesis of Compound 11

In the same manner as in Synthesis Example 2 except that in the step [2-2], 2-triphenyleneboronic acid was used in place of (4-(diphenylamino)phenyl)boronic acid, an orange solid of Compound 11 was produced. Yield: 0.37 g, 70%.

$^1H$ NMR (500 MHz, DMSO-$D_6$) δ 7.68-7.72 (m, 3H), 7.75-7.79 (m, 4H), 7.83-7.90 (m, 7H), 8.43 (s, 1H), 8.49 (s, 1H), 8.73-8.75 (d, *J*= 10.0 Hz, 2H), 8.79 (m, 3H), 8.85 (s, 1H), 9.06-9.08 (m, 1H); $^{13}C$ NMR (125 MHz, DMSO-$D_6$) δ 58.89, 59.74, 115.56, 115.64, 119.06, 119.15, 119.22, 123.90, 124.01, 124.54, 124.75, 124.85, 124.89, 125.48, 127.37, 127.69, 127.83, 128.09, 129.32, 129.63, 129.84, 129.86, 130.18, 130.60, 130.70, 132.77, 132.86, 134.72, 138.63, 146.76; $^{31}P$ NMR (202 MHz, DMSO-$D_6$) δ 9.34; MS(ASAP): *m/z* calcd. for $C_{37}H_{23}N_2P$: 526.1599 ([M]+); found. 527.39.

(Synthesis Example 10) Synthesis of Compound 12

In the same manner as in Synthesis Example 2 except that in the step [2-2], 2-triphenyleneboronic acid was used in place of (4-(diphenylamino)phenyl)boronic acid, a yellow solid of Compound 12 was produced. Yield: 0.24 g, 60%.

$^1H$ NMR (500 MHz, DMSO-$D_6$) δ 7.69-7.76 (m, 8H), 7.80-7.89 (m, 6H), 8.22 (s, 1H), 8.28 (s, 1H); $^{13}C$ NMR (125 MHz, DMSO-$D_6$) δ 59.91, 60.77, 107.98, 113.77, 113.85, 118.57, 118.67, 119.66, 124.19, 124.92, 125.41, 130.63, 130.74, 132.80, 132.89, 132.97, 134.90, 144.00, 146.85; $^{31}P$ NMR (202 MHz, DMSO-$D_6$) δ 8.82; MS(ASAP): *m/z* calcd. for $C_{26}H_{16}N_3P$: 401.1082 ([M]+1); found. 402.20.

(Synthesis Example 11) Synthesis of Compound 13

Compound 1 (600 mg, 2.0 mmol) was dissolved in dimethylformamide (5 ml), then phosphoryl chloride (357 mg, 2.3 mmol, 1.15 equivalent) was added at room temperature, and stirred at 60°C for 3 hours. The mixture was cooled down to room temperature, water was added, and stirred for 10 minutes to stop the reaction. An aqueous saturated sodium hydrogen carbonate solution was added, and the resultant basic solution was extracted five times with ethyl acetate. The organic layer was washed with brine, dried with sodium sulfate, and concentrated in vacuum. The resultant residue was roughly purified through silica gel column chromatography using ethyl acetate/trichloromethane (1/2) as an eluent, and recrystallized from a mixed solvent of chloroform/diethyl ether to give a yellow solid of Compound 13. Yield: 0.55 g, 84%.

$^1H$ NMR (500 MHz, DMSO-$D_6$) δ 7.72-7.76 (q,*J* = 5.0 Hz, 4H), 7.81-7.85 (m, 4H), 7.89-7.92 (t, *J* = 7.5 Hz, 2H) 8.29 (s, 1H), 8.35 (s, 1H), 9.25 (s, 1H); $^{13}C$ NMR (125 MHz, DMSO-$D_6$) δ 114.90, 114.97, 116.14, 116.24, 121.45, 122.19, 129.76, 129.87, 131.99, 132.09, 134.33, 134.36, 186.07; $^{31}P$ NMR (202 MHz, DMSO-$D_6$) δ 11.09; MS(ASAP): *m/z* calcd. for $C_{20}H_{13}N_2OP$: 328.0765 ([M]+1); found. 329.16.

The emission-excited singlet energy level of $E_{S1}$ and the emission-excited triplet energy level $E_{T1}$ of Compound 1 used in the following Examples, and the emission-excited singlet energy level of $E(B)_{S1}$ and the emission-excited triplet energy level $E(B)_{T1}$ of Compound B1 used therein are shown in Table 1.

[Table 1]

| | Emission-Excited Singlet Energy Level $E_{S1}$, $E(B)_{S1}$ | Emission-Excited Triplet Energy Level $E_{T1}$, $E(B)_{T1}$ |
|---|---|---|
| Compound 1 | 2.68 eV | 2.24 eV |
| Compound B1 | 2.97 eV | 2.02 eV, 1.48 eV |

[2] Evaluation of PL characteristics and ASE characteristics

(Evaluation of emission wavelength)

Compounds 1 to 3, 5 and 7 to 12 were individually dissolved in toluene in a glove box in a nitrogen atmosphere to prepare toluene solutions (concentration $10^{-5}$ mol/L), the emission spectra thereof with a 350-nm excitation light were measured. The results are shown in Fig. 2.

Compounds 1 to 3, 5 and 7 to 12 tested here were all compounds represented by the formula (1), differing from each other in the structure of $R^3$. As shown in Fig. 2, the emission peak of the toluene solution of the compound varied in a broad range of 450 to 700 nm depending on the structure of $R^3$ of the compound of the solution. The emission peak of Compound 12 where $R^3$ is an electrophilic group appears on the short wavelength side, and as the electron-donating property of $R^3$ increases, the emission peak tends to shift toward the longer wavelength side. From this, it is known that, by controlling the type and the structure of $R^3$ in the formula (1), the emission color can be finely controlled in a broad range.

(Production of thin film samples)

According to a vacuum evaporation method under the condition of a vacuum degree of $10^{-4}$ Pa or less, a thin film (single film) of Compound 1 and a thin film (single film) of Compound B 1 were formed on a quartz substrate each in a thickness of 200 nm.

Also on a quartz substrate according to a vacuum evaporation method under the condition of a vacuum degree of $10^{-4}$ Pa or less, a thin film (mixed film) of Compound 1 and Compound B 1 was formed in a thickness of 200 nm by co-evaporation from different evaporation sources. At that time, the concentration of Compound 1 was 0.5% by weight or 1.0% by weight, and two types of mixed films differing in the concentration of Compound 1 therein were formed.

Further, according to a spin coating method, a polymer film of Compound 1 and polymethyl methacrylate (PMMA) was formed on a quartz substrate in a thickness of 200 nm. At that time, the concentration of Compound 1 was 1.0% by weight.

(Evaluation of light absorption characteristics and PL emission characteristics)

Thus produced, the single films and the mixed film where the concentration of Compound 1 was 1.0% by weight were measured for the light absorption spectrum and the emission spectrum with a 337-nm excitation light at a room temperature. The results are shown in Fig. 3. In Fig. 3, (Abs) indicates an absorption spectrum, and (PL) indicates an emission spectrum.

As shown in Fig. 3, every film had an absorption peak and an emission peak, and the emission wavelength range of the single film of Compound B1 and the absorption wavelength range of the single film of Compound 1 overlapped greatly. This means that in the mixed film of Compound 1 and Compound B1, almost all energy by light absorption of Compound B 1 was transferred to Compound 1 to be consumed for emission of Compound 1. From this, the emission of the mixed film results from Compound 1.

The mixed film was tried for a phosphorescent spectrum at 77 K, but no phosphorescent emission was observed. From this, it is known that the excitons generated by Compound 1 by the energy received from Compound B1 are mainly singlet excitons.

Of the single film of Compound B1, the mixed film containing 1.0% by weight of Compound 1 and Compound B1, and the polymer film containing 1.0% by weight of Compound 1, the emission lifetime measured at 300 K, the photoluminescent quantum yield (PLQY), and the radiation decay constant are shown in Table 2. In Table 2, in the column of "mixed film of 1% by weight of Compound 1 and Compound B1", the wavelength range of 350 to 420 nm indicates a region where the emission of Compound B1 is dominant, and the wavelength range of 550 to 700 nm indicates a region where the emission of Compound 1 is dominant.

[Table 2]

| Thin Film Sample | Emission Lifetime (ns) | PLQY | radiation decay constant ($s^{-1}$) |
|---|---|---|---|
| Single film of Compound 1 | 1.14 | 0.78 | 6.84E+08 |
| Polymer film containing 1 wt% Compound 1 | 5.29 | 0.79 | 1.49E+08 |
| Mixed film of 1 wt% Compound 1 and Compound B1 (350 to 420 nm) | 0.05 | 1 | 2.00E+10 |
| Mixed film of 1 wt% Compound 1 and Compound B1 (550 to 700 nm) | 8.83 | 0.83 | 9.39E+07 |

As shown in Table 2, the polymer film containing Compound 1 and the mixed film of Compound 1 and Compound B1 both showed a high PLQY, but PLQY of the mixed film was higher than PLQY of the polymer film. As seen above, the mixed film of Compound 1 and Compound B1 attained a high PLQY, and this is presumed to be because of the following mechanism since the emission-excited singlet energy level $E_{S1}$ of Compound 1 is lower than the emission-excited singlet energy level $E(B)_{S1}$ of Compound B1 ($E_{S1}<E(B)_{S1}$), and since the emission-excited triplet energy level $E_{T1}$ of Compound 1 is higher than the emission-excited triplet energy level $E(B)_{T1}$ of Compound B1 ($E_{T1}>E(B)_{T1}$).

Namely, since ($E_{S1}<E(B)_{S1}$), the excited singlet energy generated in Compound B1 transfers to the emission-excited singlet energy level $E_{S1}$ of Compound 1 by the Foerster transfer mechanism, as shown in Fig. 4. With that, Compound 1 becomes to be in an emission-excited singlet state to emit light, and a part of Compound 1 that has been in an emission-excited single state undergoes intersystem crossing from the emission-excited singlet state to an emission-excited triplet state to transition to be in the emission-excited triplet state. Here, the emission-excited triplet state has a long lifetime, and accordingly in the case where there is no destination of energy, the energy may accumulate there to be in a high density, therefore causing singlet-triplet annihilation to lower PLQY. As opposed to this, when $E_{T1}>E(B)_{T1}$ is satisfied, the excited triplet energy of Compound 1 transfers to the emission-excited triplet energy level $E(B)_{T1}$ of Compound B1 by the Dexter transfer mechanism, and accumulation of the excited triplet state in Compound 1 can be thereby suppressed. As a result, it is presumed that the singlet-triplet annihilation to be induced by accumulation of the excited triplet state can be suppressed and a high PLQY can be attained.

In that manner, in addition, in the case where the compound represented by the formula (1) and the compound represented by the formula (2) satisfy the above-mentioned energy relationship, the compound represented by the formula (2) also functions as a quencher to quench the excited triplet, and therefore, even when any other triplet quencher is not added, the lasing characteristics can be thereby improved. Accordingly, addition of any other triplet quencher is unnecessary, and the present invention provides an additional effect of simplifying material planning.

Compound B1 used here has two vibration levels at the emission-excited triplet energy level $E(B)_{T1}$, and it is sufficient that at least the lower vibration level could satisfy $E_{T1}>E(B)_{T1}$, but preferably both the low vibration level and the high vibration level (all vibration levels) satisfy the relationship.

(Evaluation of ASE characteristics)

The mixed film where the concentration of Compound 1 is 0.5% by weight and the mixed film where the concentration of Compound 1 is 1.0% by weight were analyzed for the excitation light intensity dependence of the emission peak with a 337-nm excitation light, and as a result, the emission intensity greatly increased at a certain excitation light intensity or more and the half-value width became narrow to give an ASE peak. ASE threshold was determined, and was 1.07 $\mu J/cm^2$ at the 0.5 wt% concentration, and 1.12 $\mu J/cm^2$ at the 1.0 wt% concentration. The half-value width of the ASE peak was 3 nm or less at the 0.5 wt% concentration and 3 nm or less at the 1.0 wt% concentration when the excitation light intensity is 2 $\mu J/cm^2$, that is, an extremely narrow half-value width was realized. Further, the mixed film where the concentration of Compound 1 is 0.5% by weight was irradiated with an excitation light at 25.76 $\mu J/cm^2$ for a predetermined period of time, and the mixed film where the concentration of Compound 1 is 1.0% by weight was irradiated with an excitation light at 25.566 $\mu J/cm^2$ for a predetermined period of time, and the ASE intensity change was investigated. Both showed a stable ASE intensity for a period of 5 hours or more. This suggests that when the mixed film is applied to a laser device, the device can have stable lasing characteristics.

In that manner, stable ASE emission was realized for a long period of time, and this is considered because Compound 1 received the excited singlet energy that Compound B1 obtained by optical absorption, and inverted distribution was smoothly formed in Compound 1, and because in Compound 1, the induced emission speed from the excited singlet state by spontaneous emission was far higher than the speed of intersystem crossing from the excited singlet state to the excited triplet state, and therefore excited triplet accumulation could be suppressed and dissolution of inverted

distribution by singlet-triplet annihilation could thereby be suppressed.

[3] Production and evaluation of optically pumped laser device

(Example 1) Production of optically pumped laser device 1 having mixed gratings of primary gratings and secondary gratings

The laser device produced here is a distributed-feedback (DFB) optically pumped laser device having a layer configuration shown in Fig. 5. The distributed-feedback optically pumped laser device 10 is composed of a glass substrate 11, a DFB grating 12, a mixed layer (light-emitting layer) of Compound 1 and Compound B1, an amorphous layer (Gytop, available from AGC Inc.) 14 and a sapphire layer 15 laminated in that order. In this Example, the laser device shown in Fig. 5 was produced as follows.

On a glass substrate 11, an $SiO_2$ layer was formed having a thickness of 65 nm, according to a sputtering method. Subsequently, the $SiO_2$ layer was patterned by electron beam lithography and reactive ion etching to form DFB gratings 12 in a region of 740 μm × 740 μm. Here, formed were mixed gratings of primary gratings at a grating period $p^1$ of 148 nm and secondary gratings at a grating period $p^2$ of 296 nm, as alternately disposed in a grating height h of 65 nm. The length of the primary grating formation region and the secondary grating formation region were 592 nm and 888 nm, respectively. Next, on the surface of the thus-formed DFB gratings, a mixed film of Compound 1 and Compound B1 was formed in a thickness of 200 nm according to a co-evaporation method to be a light-emitting layer 13. At that time, the concentration of Compound 1 was 1% by weight. Subsequently, an amorphous layer 14 and a sapphire layer 15 to be protective layers were layered in that order to give a DFB laser device (laser device 1).

(Example 2) Production of optically pumped laser device 2 having primary gratings

A laser device 2 was produced in the same manner as in Example 1, except that, as DFB gratings, primary gratings alone were formed in place of forming mixed gratings.

(Example 3) Production of optically pumped laser device 3 having secondary gratings

A laser device 3 was produced in the same manner as in Example 1, except that, as DFB gratings, secondary gratings alone were formed in place of forming mixed gratings.

Of the laser device 1, the emission lifetime with a 337-nm excitation light was measured while the excitation intensity was varied. The measurement results are shown in Table 3. In Table 3, "excitation laser output" is shown as a relative value to the maximum output 100 μJ/cm². The emission lifetime was determined by fitting the emission attenuation curve.

[Table 3]

| Excitation Laser Output (%) | taul (ns) | tau2 (ns) |
|---|---|---|
| 0 | 0.05277 | 3.06371 |
| 50 | 0.04862 | 2.63904 |
| 60 | 0.03571 | 2.57158 |
| 70 | 0.03364 | 2.46785 |
| 80 | 0.02043 | 2.40872 |
| 90 | 0.01796 | 2.24259 |

As shown in Table 3, two types of fluorescent lifetime taul and tau2 were measured from the laser device 1, and with the increase in the excitation laser output, the lifetimes tended to shorten.

The laser devices 1 to 3 were also measured for the emission spectra with a 337-nm excitation light, with varying the excitation intensity under a short pulse condition of 3.5 ns. In these, the emission intensity suddenly increased at a specific excitation intensity or more and the half-value width narrowed, and these devices were recognized to have given laser oscillation. In addition, in the case where the emission spectra with a 355-nm excitation light were measured with varying the excitation intensity under a continuous oscillation condition, laser oscillation was also recognized at a specific excitation intensity or more. The lasing threshold under each excitation condition is as shown in Table 4, in which all values were low.

[Table 4]

| Laser Device No. | Gratings | Lasing Threshold | |
|---|---|---|---|
| | | Short Pulse λex = 337 nm (μJ/cm$^2$) | Continuous Oscillation: λex = 355 nm (W/cm$^2$) |
| Laser Device 1 | mixed-order gratings | 0.86 | 72.28 |
| Laser Device 2 | primary gratings | 0.18 | - |
| Laser Device 3 | secondary gratings | 0.91 | 75.85 |
| Mixed Film of Compound 1 and Compound B 1 | - | 1.1 (ASE threshold) | - |

For investigating the coherence (phase coherence) of the laser light from the laser device 1, interferometry was carried out between the near field and the far field. The beam cross section in the far field well was well coincident with the beam cross section determined by theoretical calculation, and in the nearfield pattern, some interference fringes were observed. This confirms that the laser light from the laser device 1 is a highly coherent light.

[4] Production and evaluation of current-excited laser device

(Example 4) Production of current-excited laser device 4 having mixed gratings of primary gratings and secondary gratings

The laser device produced here is a distributed-feedback (DFB) current-excited laser device having a layer configuration shown in Fig. 6. The distributed-feedback current-excited laser device 20 is composed of a glass substrate 21, a first electrode 22 of indium tin oxide (ITO), DFB gratings 23, a mixed layer 24 of cesium (Cs) and Compound B1, a mixed layer (light-emitting layer) 25 of Compound 1 and Compound B1, a molybdenum trioxide ($MoO_3$) layer 26, and a second electrode 27 of aluminum (Al) laminated in that order. Here, the mixed layer of cesium and Compound B1 functions as an electron injection layer to promote electron injection into the light-emitting layer, and the molybdenum oxide layer functions as a hole injection layer to promote hole injection into the light-emitting layer. In this Example, the laser device shown in Fig. 6 was produced as follows.

A glass substrate 21 having, as formed thereon, a first electrode 22 of ITO having a thickness of 30 nm was prepared. On ITO, an $SiO_2$ layer was formed to have a thickness of 65 nm according to a sputtering method. Subsequently, like in Example 1, DFB gratings 23 as mixed gratings were formed in a region of 740 μm × 740 μm.

Next, on the surface of the thus-formed DFB gratings 23, thin films were laminated according to a vacuum evaporation method under a vacuum degree of $10^{-4}$ Pa.

First, a mixed layer 25 of cesium and Compound B1 was formed to have a thickness of 30 nm between the DFB gratings 23 according to a co-evaporation method. At that time, the concentration of cerium was 20% by weight. Next, also according to a co-evaporation method, a mixed film of Compound 1 and Compound B 1 was formed to have a thickness of 180 nm as a light-emitting layer 25. At that time, the concentration of Compound 1 was 1% by weight. Subsequently, molybdenum trioxide 26 was formed to have a thickness of 10 nm, and further aluminum was vapor-deposited to have a thickness of 50 nm as a second electrode 27 thereby giving a DFB laser device (laser device 4).

(Example 5) Production of current-excited laser device 5 having primary gratings

A laser device 5 was produced in the same manner as in Example 4, except that, as DFB gratings, primary gratings alone were formed in place of forming mixed gratings.

(Example 6) Production of current-excited laser device 6 having secondary gratings

A laser device 6 was produced in the same manner as in Example 4, except that, as DFB gratings, secondary gratings alone were formed in place of forming mixed gratings.

(Reference Example) Production of organic electroluminescent device

An organic electroluminescent device for reference (EL device for reference) was produced in the same manner as in Example 4, except that DFB gratings were not formed.

Of the laser devices 4 and 6 and the EL device for reference, the emission spectra were measured at room temperature and under the pulse conditions of a pulse width of 400 nm and a repetitive frequency of 1 kHz, while the current density was varied in a range of 500 to 22200 mA/cm$^2$. With the laser device 4, a phenomenon was seen such that the half-value width of the emission peak remarkably narrowed around the center of 530 nm at a specific current density or more; and with the laser device 6, a phenomenon was seen such that the half-value width of the emission peak remarkably narrowed around the center of 505 nm at a specific current density or more. On the other hand, with the EL device for reference, there was not seen remarkable narrowing of the half-value width like that seen with the laser devices 4 and 6. From this, it is seen that the remarkable narrowing of the half-value width observed with the laser devices 4 and 6 is caused by the lasing phenomenon owing to the gratings, and the laser devices 4 and 6 exhibit laser oscillation. In addition, the laser device 4 attained a high external quantum efficient of at most 22%. Further, a current density over the threshold was given to the laser devices 4 and 6, and the emitted light was observed through a polarizer to determine the polarizer angle dependence of the emission intensity. As a result, it was confirmed that the emitted light was strongly linearly polarized along the pattern of the primary gratings.

Industrial Applicability

The compound of the present invention is a novel lasing material that differs from BSBCz in the skeleton structure. Consequently, using the compound, a laser device can realize a variety of emission wavelengths and lasing characteristics, that is, the compound enhances the versatility of organic laser devices. Accordingly, the industrial applicability of the present invention is great.

Reference Signs List

| | |
|---|---|
| 1 | Substrate |
| 2 | Anode |
| 3 | Hole Injection Layer |
| 4 | Hole Transport Layer |
| 5 | Light-Emitting Layer |
| 6 | Electron Transport Layer |
| 7 | Cathode |
| 11,21 | Glass Substrate |
| 12, 23 | DFB Gratings |
| 13, 25 | Light-Emitting Layer |
| 14 | Amorphous Layer |
| 15 | Sapphire Layer |
| 22 | First Electrode |
| 24 | Mixed Layer of Cesium and Compound B 1 |
| 26 | Molybdenum Trioxide Layer |
| 27 | Second Electrode |

**Claims**

**1.** A laser device containing a compound represented by the following formula (1) in a light-emitting layer:

Formula (1)

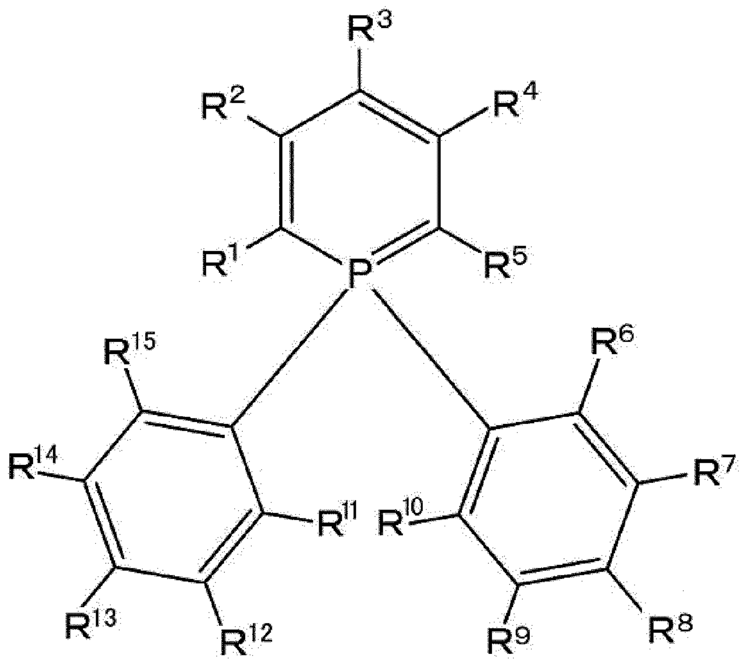

wherein $R^1$ and $R^5$ each independently represent a substituent having a positive Hammett's $\sigma_p$ value, and $R^2$ to $R^4$, and $R^6$ to $R^{15}$ each independently represent a hydrogen atom or a substituent.

2. The laser device according to claim 1, wherein $R^1$ and $R^5$ each are independently a cyano group, an aryl group substituted with a cyano group, or a heteroaryl group having a nitrogen atom as a ring skeleton constituting atom, and wherein the aryl group may be further substituted with any other group than a cyano group and the heteroaryl group may be substituted.

3. The laser device according to claim 1 or 2, wherein $R^2$ to $R^4$ each are independently a hydrogen atom or a substituent having a positive Hammett's $\sigma_p$ value.

4. The laser device according to claim 3, wherein the substituent having a positive Hammett's $\sigma_p$ value is an aryl group substituted with a cyano group, and wherein the aryl group may be further substituted with any other group than a cyano group.

5. The laser device according to claim 1 or 2, wherein $R^2$ to $R^4$ each are independently a hydrogen atom or a substituent having a negative Hammett's $\sigma_p$ value.

6. The laser device according to claim 5, wherein the substituent having a negative Hammett's $\sigma_p$ value is a group containing a substituted or unsubstituted diarylamino structure.

7. The laser device according to claim 6, wherein the group containing a substituted or unsubstituted diarylamino structure contains a linking group that links the diarylamino structure to the phosphinine ring in the formula (1).

8. The laser device according to claim 1 or 2, wherein $R^2$ to $R^4$ each are independently a hydrogen atom, a substituted or unsubstituted aryl group, or a group represented by $R^{16}CO$-, and $R^{16}$ represents a hydrogen atom or a substituent.

9. The laser device according to claim 8, wherein the substituted or unsubstituted aryl group contains a condensed ring having a benzene ring unit.

10. The laser device according to any one of claims 1 to 9, wherein $R^3$ is a substituent.

11. The laser device according to any one of claims 1 to 10, containing a compound represented by the following formula

(2) in the light-emitting layer:

Formula (2) $Z^1\text{-}L\text{-}Z^2$

wherein $Z^1$ and $Z^2$ each independently represent a substituted or unsubstituted diarylamino group, and the two aryl groups constituting the diarylamino group bond to each other directly or via a linking group, L represents a conjugated linking group that contains both a substituted or unsubstituted arylene group and a substituted or unsubstituted ethenylene group.

**12.** The laser device according to claim 11, wherein the content of the compound represented by the formula (1) in the light-emitting layer is 0.01 to 10% by mass, and the content of the compound represented by the formula (2) therein is larger than the content of the compound represented by the formula (1).

**13.** The laser device according to claim 11 or 12, wherein the emission-excited singlet energy level of the compound represented by the formula (1) is lower than the emission-excited singlet energy level of the compound represented by the formula (2), and the emission-excited triplet energy level of the compound represented by the formula (1) is higher than the emission-excited triplet energy level of the compound represented by the formula (2).

**14.** A compound represented by the following formula (3):

Formula (3)

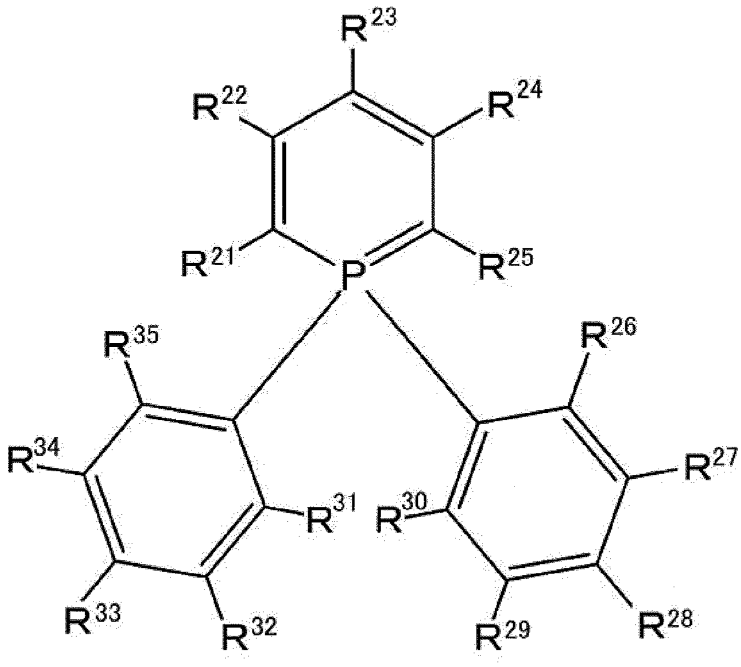

wherein $R^{21}$ and $R^{25}$ each independently represent a substituent having a positive Hammett's $\sigma_p$ value, $R^{23}$ represents a substituent, $R^{22}$, $R^{24}$, and $R^{26}$ to $R^{35}$ each independently represent a hydrogen atom or a substituent, provided that when $R^{21}$ and $R^{25}$ each are a cyano group, $R^{23}$ is a substituted aryl group, or a substituted or unsubstituted heteroaryl group.

**15.** The compound according to claim 14, wherein $R^{23}$ is a substituted aryl group.

**16.** The compound according to claim 14 or 15, wherein $R^{21}$ and $R^{25}$ each are a cyano group.

**17.** A method for producing a compound represented by a formula (4), comprising a step of halogenating the 4-position of a 2,6-dicyano-1,1-diphenylphosphinine in which the 4-position is unsubstituted and the other position may be substituted, and a step of afterward reacting it with a compound represented by $R^{43}$-H:

Formula (4)

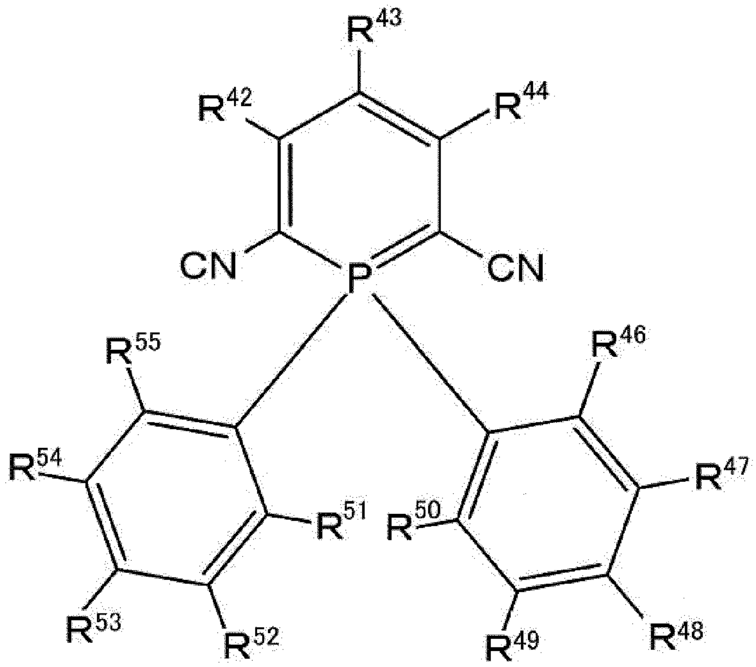

wherein $R^{43}$ represents a substituted aryl group, or a substituted or unsubstituted heteroaryl group, and $R^{42}$, $R^{44}$, and $R^{46}$ to $R^{55}$ each independently represent a hydrogen atom or a substituent.

**18.** A lasing sensitizer containing a compound represented by the following formula (2):

Formula (2) $Z^1$-L-$Z^2$

wherein $Z^1$ and $Z^2$ each independently represent a substituted or unsubstituted diarylamino group, and the two aryl groups constituting the diarylamino group bond to each other directly or via a linking group, L represents a conjugated linking group that contains both a substituted or unsubstituted arylene group and a substituted or unsubstituted ethenylene group.

**19.** A laser device having a light-emitting layer that contains a lasing sensitizer of claim 18 and a light-emitting material, wherein:
the emission-excited singlet energy level of the light-emitting material is lower than the emission-excited singlet energy level of the lasing sensitizer, and the emission-excited triplet energy level of the light-emitting material is higher than the emission-excited triplet energy level of the lasing sensitizer.

[FIG. 1]

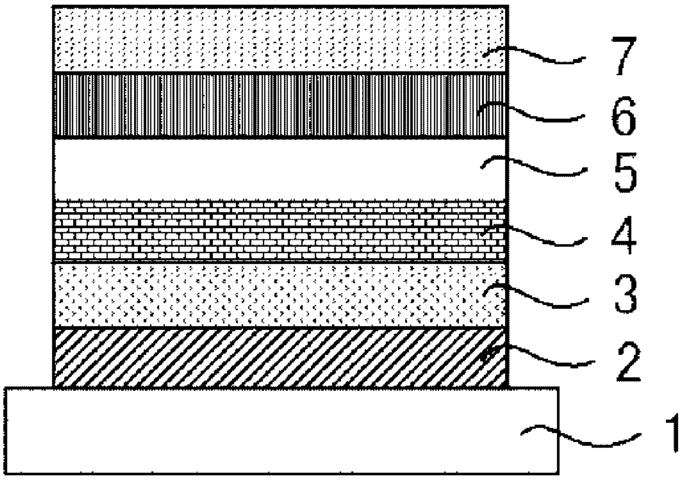
7
6
5
4
3
2
1

[FIG. 2]

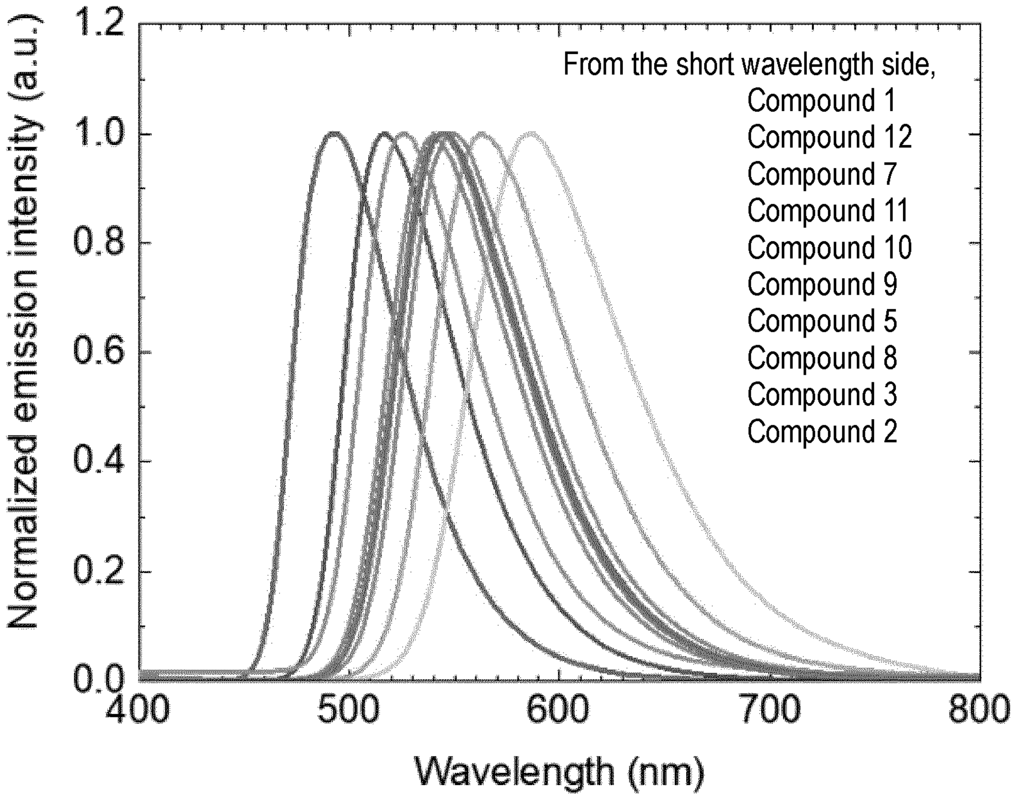
Normalized emission intensity (a.u.)
1.2
1.0
0.8
0.6
0.4
0.2
0.0
400
500
600
700
800
Wavelength (nm)
From the short wavelength side,
Compound 1
Compound 12
Compound 7
Compound 11
Compound 10
Compound 9
Compound 5
Compound 8
Compound 3
Compound 2

[FIG. 3]

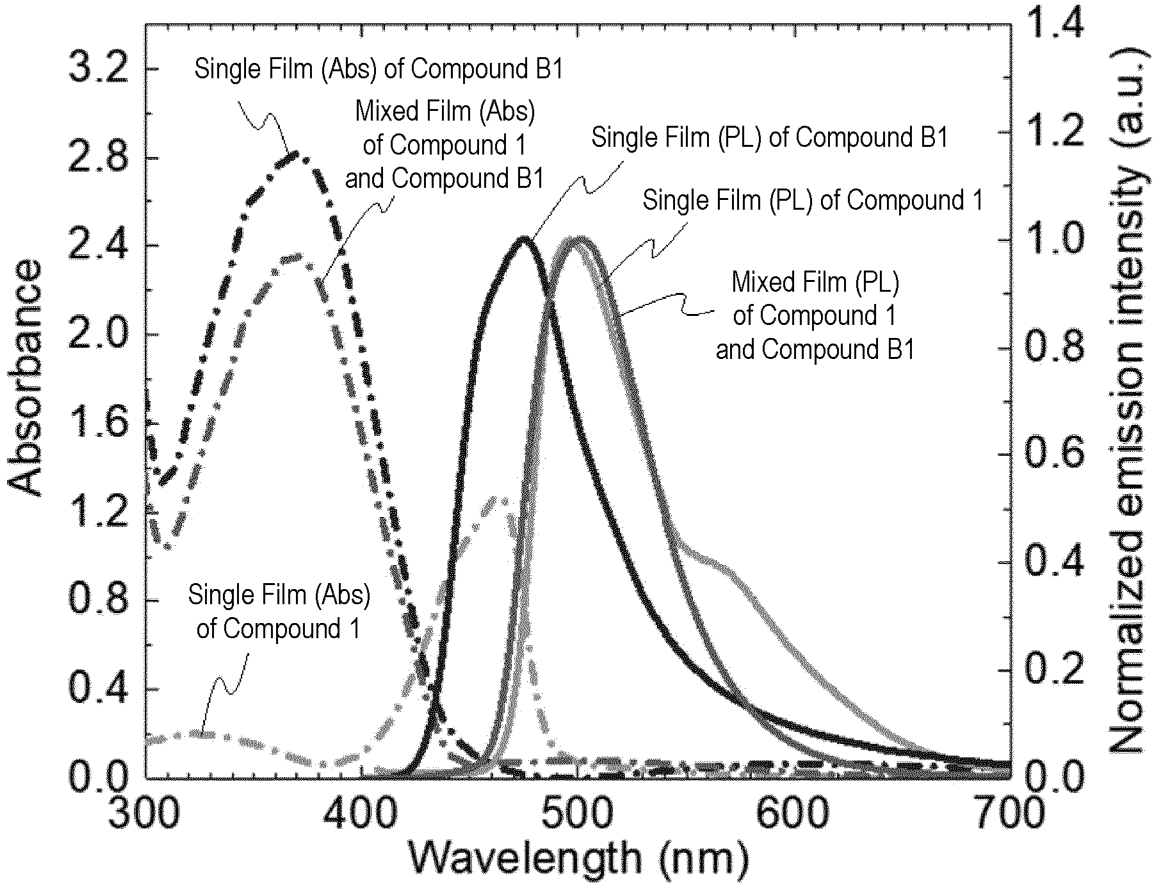

Single Film (Abs) of Compound B1
Mixed Film (Abs) of Compound 1 and Compound B1
Single Film (PL) of Compound B1
Single Film (PL) of Compound 1
Mixed Film (PL) of Compound 1 and Compound B1
Single Film (Abs) of Compound 1
Absorbance
Normalized emission intensity (a.u.)
Wavelength (nm)
3.2
2.8
2.4
2.0
1.6
1.2
0.8
0.4
0.0
1.4
1.2
1.0
0.8
0.6
0.4
0.2
0.0
300
400
500
600
700

[FIG. 4]

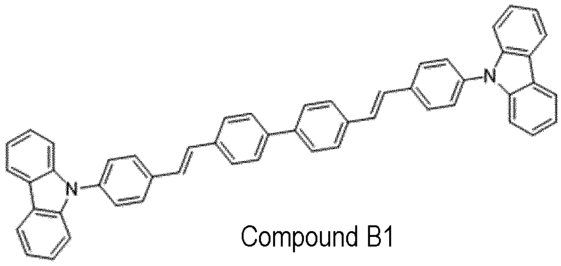

Compound B1

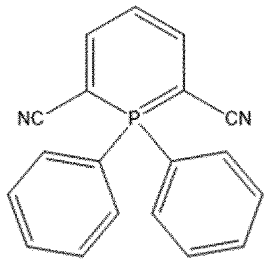

Compound 1

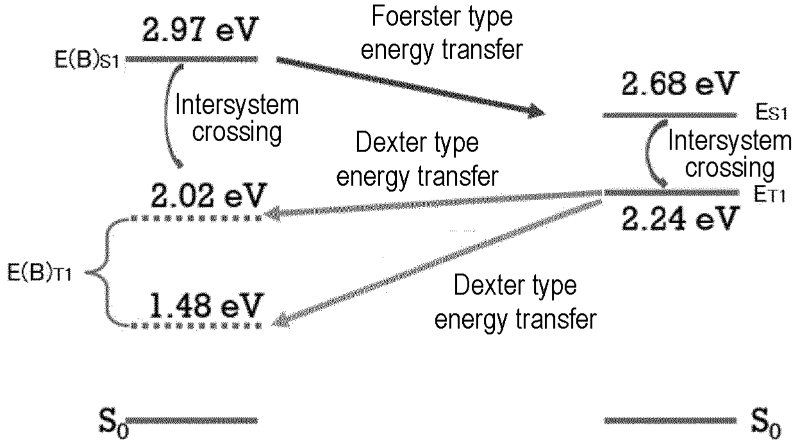



[FIG. 5]

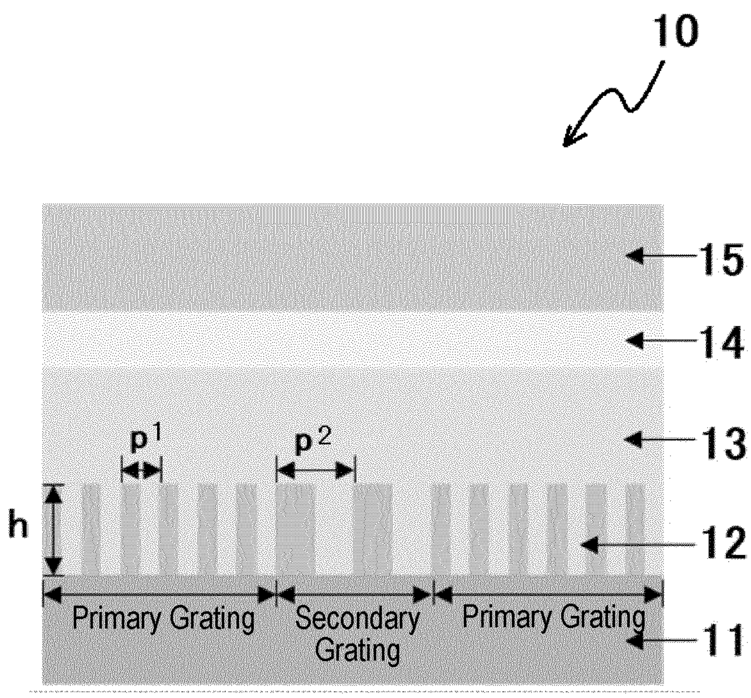

[FIG. 6]

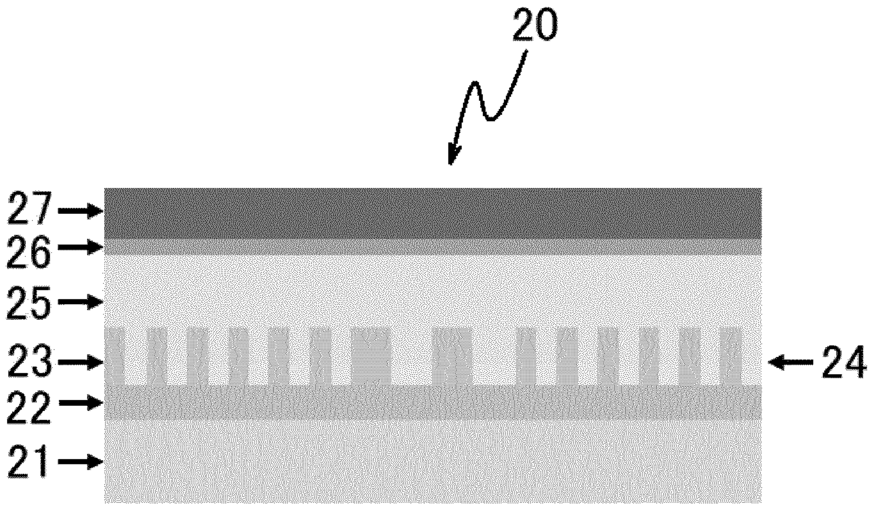

**INTERNATIONAL SEARCH REPORT**

International application No. PCT/JP2020/036305

A. CLASSIFICATION OF SUBJECT MATTER
C09K 11/06(2006.01)i; H01S 5/36(2006.01)i; H01L 51/50(2006.01)i
FI: H01S5/36; C09K11/06 660; H05B33/14 B

According to International Patent Classification (IPC) or to both national classification and IPC

B. FIELDS SEARCHED

Minimum documentation searched (classification system followed by classification symbols)
H01S5/00-5/50; C09K11/00-11/89; H01L51/50

Documentation searched other than minimum documentation to the extent that such documents are included in the fields searched

| | |
|---|---|
| Published examined utility model applications of Japan | 1922-1996 |
| Published unexamined utility model applications of Japan | 1971-2020 |
| Registered utility model specifications of Japan | 1996-2020 |
| Published registered utility model applications of Japan | 1994-2020 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X<br>A | HASHIMOTO et al., "Synthesis and Photophysical Properties of λ5-Phosphinines as a Tunable Fluorophore", JOURNAL OF THE AMERICAN CHEMICAL SOCIETY, 05 February 2018, vol. 140, pp. 2046-2049, fig. 1-3, scheme 1-3 | 14-17<br>1-13, 18-19 |
| A | JP 2018-174279 A (KYUSHU UNIVERSITY) 08 November 2018 (2018-11-08) entire text, all drawings | 1-19 |
| A | JP 2015-201463 A (KYUSHU UNIVERSITY) 12 November 2015 (2015-11-12) entire text, all drawings | 1-19 |
| A | WO 2019/176971 A1 (KYUSHU UNIVERSITY) 19 September 2019 (2019-09-19) entire text, all drawings | 1-19 |
| A | WO 2018/155642 A1 (KYUSHU UNIVERSITY) 30 August 2018 (2018-08-30) entire text, all drawings | 1-19 |
| A | JP 2018-35124 A (KYUSHU UNIVERSITY) 08 March 2018 (2018-03-08) entire text, all drawings | 1-19 |

☒ Further documents are listed in the continuation of Box C. ☒ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 26 November 2020 (26.11.2020) | 08 December 2020 (08.12.2020) |
| Name and mailing address of the ISA/<br>Japan Patent Office<br>3-4-3, Kasumigaseki, Chiyoda-ku,<br>Tokyo 100-8915, Japan | Authorized officer<br><br>Telephone No. |

Form PCT/ISA/210 (second sheet) (January 2015)

**INTERNATIONAL SEARCH REPORT**

International application No.
PCT/JP2020/036305

C (Continuation). DOCUMENTS CONSIDERED TO BE RELEVANT

| Category* | Citation of document, with indication, where appropriate, of the relevant passages | Relevant to claim No. |
|---|---|---|
| A | JP 2003-142263 A (MATSUSHITA ELECTRIC INDUSTRIAL CO., LTD.) 16 May 2003 (2003-05-16) entire text, all drawings | 1-19 |
| A | JP 2018-512726 A (NOVALED GMBH) 17 May 2018 (2018-05-17) entire text, all drawings | 1-19 |
| A | US 2013/0066092 A1 (CZERWIENIEC et al.) 14 March 2013 (2013-03-14) entire text, all drawings | 1-19 |
| A | SVYASCHENKO et al., "Electrocyclization of Phosphahexatrienes: An Approach to λ5-Phosphinines", The Journal of Organic Chemistry, 21 June 2011, vol. 76, pp. 6125-6133, fig. 1, scheme 1-5 | 1-19 |
| A | AIMONO et al., "100% fluorescence efficiency of 4,4'-bis[(N-carbazole)styryl]biphenyl in a solid film and the very low amplified spontaneous emission threshold", APPLIED PHYSICS LETTERS, 09 February 2005, vol. 86, page 071110, fig. 1-3 | 1-19 |
| A | SCHAFER et al., "Nature of Bonding in λ5-Phosphorins", Journal of the American Chemical Society, 21 July 1976, vol. 98, no. 15, pp. 4410-4418, entire text, all drawings | 1-19 |

Form PCT/ISA/210 (continuation of second sheet) (January 2015)

**INTERNATIONAL SEARCH REPORT**
Information on patent family members

International application No.
PCT/JP2020/036305

| Patent Documents referred in the Report | Publication Date | Patent Family | Publication Date |
|---|---|---|---|
| JP 2018-174279 A | 08 Nov. 2018 | US 2020/0035921 A1<br>entire text, all drawings<br>WO 2018/180838 A1<br>EP 3605756 A1<br>CN 110582905 A<br>KR 10-2019-0135483 A | |
| JP 2015-201463 A | 12 Nov. 2015 | WO 2014/024856 A1<br>entire text, all drawings | |
| WO 2019/176971 A1 | 19 Sep. 2019 | (Family: none) | |
| WO 2018/155642 A1 | 30 Aug. 2018 | EP 3587399 A1<br>entire text, all drawings<br>CN 110366548 A<br>KR 10-2019-0120789 A | |
| JP 2018-35124 A | 08 Mar. 2018 | WO 2018/043241 A1<br>entire text, all drawings | |
| JP 2003-142263 A | 16 May 2003 | (Family: none) | |
| JP 2018-512726 A | 17 May 2018 | US 2018/0076397 A1<br>entire text, all drawings<br>US 2018/0145263 A1<br>WO 2016/131918 A1<br>WO 2016/180891 A1<br>EP 3059776 A1<br>EP 3093288 A1<br>CN 107251260 A<br>KR 10-2017-0118170A<br>KR 10-2018-0005199 A<br>CN 107750404 A | |
| US 2013/0066092 A1 | 14 Mar. 2013 | WO 2011/098522 A1<br>entire text, all drawings<br>DE 102010007825 A1 | |

Form PCT/ISA/210 (patent family annex) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Non-patent literature cited in the description

- *Appl. Phys. Lett.,* 2005, vol. 86, 071110
- **HANSCH, C.** *Chem. Rev.,* 1991, vol. 91, 165-195